# EUROPEAN PATENT APPLICATION

(11) **EP 3 832 695 A1**
(43) Date of publication of application: **09.06.2021**
(21) Application number: 19841230.6
(22) Date of filing: 26.07.2019
(51) Int. Cl.: H01L 21/027, B29C 33/38, B29C 59/16, G03F 7/20

(54) **MOLDED ARTICLE MANUFACTURING METHOD, IMPRINT-ELECTRONIC WRITING COLLECTIVE MOLDING RESIST, REPLICA MOLD MANUFACTURING METHOD, DEVICE MANUFACTURING METHOD, AND IMPRINT MATERIAL**

(30) Priority: 27.07.2018 JP 2018141682
(71) Applicant: Tokyo University of Science Foundation, Tokyo 162-8601 (JP); Toyo Gosei Co., Ltd., Ichikawa-shi, Chiba 272-0012 (JP)
(72) Inventor: TANIGUCHI, Jun, Tokyo 162-8601 (JP); OKABE, Takao, Tokyo 162-8601 (JP); OSAKI, Takeshi, Ichikawa-shi, Chiba 272-0012 (JP); MIYAZAWA, Takashi, Ichikawa-shi, Chiba 272-0012 (JP)
(74) Representative: Berggren Oy
(86) International application number: PCT/JP2019/029547
(87) International publication number: WO 2020/022514

(57) **Abstract**

A method of producing a molded product, the method including: pressing a mold having a surface including at least one of a concave part or a convex part against a photocurable positive electron beam resist; obtaining a molded product of the positive electron beam resist having a surface including a concave part and a convex part by irradiating the photocurable positive electron beam resist pressed against the resist with light to cure the resist; and partially decomposing the molded product of the positive electron beam resist in a region subjected to irradiation with an electron beam by irradiating the surface of the molded product of the positive electron beam resist with the electron beam.

## Description

### Technical Field

Some aspects of the present invention relate to a method of producing a molded product, a resist for collective molding with imprint-electron-beam lithography, a method of producing a replica mold, a method of producing a device, and an imprint material.

### Background Art

Three-dimensional structures having from micro-level to nano-level fineness has grown in importance due to the usefulness of the structures. In particular, complicated hybrid patterns having high-aspect ratios have been greatly demanded. Such a high-aspect ratio refers to a depth or height of each concave or convex part with respect to a width or diameter viewed from the above of a concave-convex structure. Such a hybrid pattern refers to a combination of two or more patterns of which the geometries or sizes are different.

In recent years, hybrid patterns including micro-size patterns and nano-size patterns have grown in importance. It is supposed that such hybrid patterns are applied to microfluidic devices, antireflective structures, water-repellent structures, and the like. Such a microfluidic device includes a liquid receiver and a flow path, and a difference between the processing sizes of the liquid receiver and the flow path is considerably great. In such an antireflective structure, nano-size patterns are regularly placed on a surface of a lens. Such a structure prevents irregular reflection of light. On the other hand, a lens may be processed into a micro size. Such a water-repellent structure is a structure in which a repetitive pattern seen in a living body, such as the skin structure of a shark or the surface structure of a roseleaf, is copied. The copy structure of a living body may also have a micro-size pattern and a nano-size pattern.

However, it is more difficult to produce a hybrid pattern having a higher aspect ratio and a more complicated geometry.

Conceivable examples of a method of processing a hybrid pattern include a method in which micro-size processing is mechanically performed, and nano-size processing is optically performed.

Optical processing is more suitable for fine processing than mechanical processing. In particular, a method (EBL) using an electron beam (EB) enables processing even on the order of 100 nm or less.

In light of such situations, a method disclosed in Patent Document 1 is proposed. In Patent Document 1, a resist layer sensitive to an electron beam is disposed on a substrate of which a surface has concave and convex parts, and irradiated with an electron beam to finely process the resist layer.

### Related Art Document

### Patent Document

Patent Document 1: Japanese Patent Application Laid-Open (JP-A) No. 2002-122710

### SUMMARY OF INVENTION

### Technical Problem

Patent Document 1 discloses a method in which concave and convex parts are formed on a surface of a substrate, and then a resist for electron beam lithography is further applied thereon.

It is an object of some aspects of the present invention to provide a method of producing a molded product, in which a hybrid pattern can be efficiently formed, and a resist for collective molding with imprint-electron-beam lithography.

It is an object of some aspects of the present invention to provide a method of producing a molded product, in which a hybrid pattern can be efficiently formed, a method of producing a replica mold, a method of producing a device, and an imprint material.

### Solution to Problem

The present invention includes the following embodiments.
<1> A method of producing a molded product, the method including:
   pressing a mold having a surface including at least one of a concave part or a convex part against a photocurable positive electron beam resist;
   obtaining a molded product of the positive electron beam resist having a surface including a concave part and a convex part by irradiating the photocurable positive electron beam resist pressed with the mold with light to cure the resist; and
   partially decomposing the molded product of the positive electron beam resist in a region subjected to irradiation with an electron beam by irradiating the surface of the molded product of the positive electron beam resist with the electron beam.
<2> The method of producing a molded product according to <1>, in which a width of a pattern generated by the electron beam, the pattern being formed by partially decomposing the molded product of the positive electron beam resist by the irradiation with the electron beam, is less than a width of at least one of the concave part or the convex part formed by pressing the mold.
<3> The method of producing a molded product according to <2>, in which at least a part of at least one of the concave part or the convex part has a width in a range of from 1 µm to 5 mm.
<4> The method of producing a molded product according to <2> or <3>, in which at least a part of the pattern generated by the electron beam has a width in a range of from 10 nm to 800 nm.
<5> The method of producing a molded product according to any one of <1> to <4>, in which the photocurable positive electron beam resist includes a functional group being radically polymerizable or cationically polymerizable by irradiation with light.
<6> The method of producing a molded product according to any one of <1> to <5>, in which the photocurable positive electron beam resist contains at least one prepolymer selected from the group consisting of a (meth)acrylic compound and a styrenic compound, and the prepolymer has a functional group being radically polymerizable by irradiation with light.
<7> The method of producing a molded product according to any one of <1> to <6>, in which the molded product of the positive electron beam resist contains a polymer, and a main chain of the polymer is decomposable by irradiation with an electron beam.
<8> The method of producing a molded product according to any one of <1> to <7>, the method further including performing a partial polymerization reaction of the photocurable positive electron beam resist by subjecting the photocurable positive electron beam resist to at least one of heat treatment or light irradiation treatment in advance before the pressing.
<9> The method of producing a molded product according to any one of <1> to <8>, in which, in the partially decomposing the molded product, at least one of a groove or a through-hole is formed in the molded product of the positive electron beam resist.
<10> A resist for collective molding with imprint-electron-beam lithography, the resist including a prepolymer containing a functional group being polymerizable by light irradiation, and
   in which a main chain of a polymer obtained after irradiating the prepolymer with the light is decomposable by irradiation with an electron beam.
<11> A method of producing a molded product, the method including:
   a process (a) of preparing a mold having a surface including at least one of a first concave part or a first convex part, and an imprint material;
   a process (b) of generating a bond between a plurality of molecules included in the imprint material and converting the imprint material into a first film having at least one of a second concave part or a second convex part by subjecting the imprint material to at least one of irradiation with a first energy ray or heat treatment in a state in which the imprint material is in contact with at least a part of at least one of the first concave part or the first convex part;
   a process (c) of generating a difference in a physical or chemical property between a first portion of the first film, the first portion being irradiated with a second energy ray, and a second portion other than the first portion by irradiating the first film with the second energy ray; and
   a process (d) of forming a molded product in which a structure including at least one of a third concave part or a third convex part is applied to the first film by removing either the first portion or the second portion.
<12> The method of producing a molded product according to <11>, in which in the process (b), the first film includes a polymer, and the polymer is obtained by polymerizing the imprint material by performing the at least one of the irradiation with the first energy ray or the heat treatment.
<13> The method of producing a molded product according to <12>, in which bonding or cleaving a part of the polymer in the first portion is induced by the irradiation with the second energy ray in the process (c).
<14> The method of producing a molded product according to any one of <11> to <13>, in which either the first portion or the second portion is removed by a solvent in the process (d).
<15> The method of producing a molded product according to any one of <11> to <14>, in which an irradiation angle of the second energy ray is at least one angle in a range of from 0 to 90° with respect to a normal line to a surface of the first film in the process (c).
<16> The method of producing a molded product according to any one of <11> to <15>, in which an energy of the second energy ray is greater than an energy of the first energy ray.
<17> The method of producing a molded product according to any one of <11> to <16>, in which a size of width of at least one of the third concave part or the third convex part formed in the process (d) differs from a size of width of at least one of the second concave part or the second convex part formed in the process (b).
<18> The method of producing a molded product according to <17>, in which at least a part of at least one of the second concave part or the second convex part has a width in a range of from 1 µm to 5 mm.
<19> The method of producing a molded product according to <17> or <18>, in which at least a part of at least one of the third concave part or the third convex part has a width in a range of from 10 nm to 800 nm.
<20> The method of producing a molded product according to any one of <11> to <19>, in which the imprint material contains at least one compound having at least one selected from the group consisting of a functional group being radically polymerizable, a functional group being cationically polymerizable, and a functional group being anionically polymerizable, by performing at least one of irradiation with a first energy ray or heat treatment.
<21> The method of producing a molded product according to any one of <11> to <20>, in which the imprint material contains at least one monomer selected from the group consisting of a (meth)acrylic compound and a styrenic compound, and the monomer has at least one selected from the group consisting of a functional group being radically polymerizable, a functional group being cationically polymerizable, and a functional group being anionically polymerizable, by performing at least one of irradiation with a first energy ray or heat treatment.
<22> The method of producing a molded product according to any one of <11> to <21>, in which the first film contains a polymer, and a part of the polymer is decomposable or cross-linkable by the irradiation with the second energy ray.
<23> The method of producing a molded product according to any one of <11> to <22>, further including a process of performing partial polymerization reaction of the imprint material by subjecting the imprint material to at least one of heat treatment or light irradiation treatment in advance, before the imprint material in the process (a) is brought into contact with at least one of the concave part or the convex part.
<24> The method of producing a molded product according to <23>, in which at least one of a groove or a through-hole is formed in the first film in the process (d).
<25> The method of producing a molded product according to any one of <11> to <24>, in which the molded product is a mold including two or more concave-convex patterns.
<26> A method of producing a replica mold, the method including:
   preparing a mold obtained in the method of producing a molded product according to <25>, and a resin composition for a replica mold; and
   obtaining a replica mold by transferring the two or more concave-convex patterns of the mold to the resin composition for a replica mold, and by curing the resin composition.
<27> A method of producing a device, the method including:
   preparing a mold obtained by the method of producing a molded product according to <25> or a replica mold obtained by the method of producing a replica mold according to <26>; and
   forming a pattern by transferring the two or more concave-convex patterns of the mold or the replica mold to a resin composition for transfer, and by curing the resin composition for transfer.
<28> An imprint material, including a monomer containing a functional group being polymerizable by at least one of irradiation with a first energy ray or heat treatment,
   in which a main chain or part of a polymer obtained after subjecting the monomer to heating or irradiation with light is decomposable or cross-linkable by irradiation with a second energy ray.

### Advantageous Effects of Invention

In accordance with some aspects of the present invention, a method of producing a molded product, in which a hybrid pattern can be efficiently formed, and a resist for collective molding with imprint-electron-beam lithography can be provided.

In accordance with some aspects of the present invention, a method of producing a molded product, in which a hybrid pattern can be efficiently formed, a method of producing a replica mold, a method of producing a device, and an imprint material can be provided.

### BRIEF DESCRIPTION OF DRAWINGS

Fig. 1 is a diagram for explaining an example of a method of producing a molded product in the present disclosure.
Fig. 2 is a diagram for explaining another example of the method of producing a molded product in the present disclosure.
Fig. 3 illustrates planar photographs of an imprint-molded product obtained using a mold 1 with a scanning electron microscope (SEM). Fig. 3(A) is a 300-fold enlarged planar photograph, Fig. 3(B) is a planar photograph of the further enlarged portion of L & S, and Fig. 3(C) is a planar photograph of the further enlarged portion of a dot pattern.
Fig. 4 illustrates SEM images of an imprint-molded product obtained using a mold 2. Fig. 4(A) is a planar photograph, and Fig. 4(B) is a perspective photograph.
Fig. 5(A) is a perspective SEM image of an imprint-molded product obtained using a mold 3. Fig. 5(B) is a photograph of a further enlarged portion of Fig. 5(A).
Fig. 6 illustrates SEM images of an imprint-molded product obtained using a mold 4. Fig. 6(A) is a planar photograph, and Fig. 6(B) is a perspective photograph.
Fig. 7(A) is a planar SEM image of a molded product obtained by electron beam lithography of an L & S pattern on a pillar pattern formed by imprinting. Fig. 7(B) is a photograph of a further enlarged portion of Fig. 7(A).
Fig. 8 is a planar SEM image of a molded product obtained by electron beam lithography of an L & S pattern on a hole pattern molded by imprinting. Fig. 8(B) is a photograph of a further enlarged portion of Fig. 8(A).
Fig. 9 is a planar SEM image of a molded product obtained by electron beam lithography of a dot pattern on a pillar pattern formed by imprinting. Fig. 9(B) is a photograph of a further enlarged portion of Fig. 9(A), and Fig. 9(C) is a perspective photograph.
Fig. 10 is a planar SEM photograph of a molded product obtained by electron beam lithography of a dot pattern on a microlens array formed by imprinting at an irradiation dose of 600 µC/cm².
Fig. 11(B) is a perspective SEM photograph of a molded product obtained by electron beam lithography of a dot pattern on a microlens array formed by imprinting at an irradiation dose of 1000 µC/cm². Fig. 11(A) is a photograph of a boundary between a portion irradiated with an electron beam (left side) and a portion unirradiated with an electron beam (right side), Fig. 11(C) is a photograph of an enlarged portion of Fig. 11(B), and Fig. 11(D) is a photograph of a further enlarged portion of Fig. 11(C).
Fig. 12 is a perspective SEM photograph of a molded product obtained by electron beam lithography of a dot pattern on a microlens array formed by imprinting at an irradiation dose of (A) 800 µC/cm² or (B) 600 µC/cm².
Fig. 13 illustrates a cross-sectional view of an example of an image sensor obtained by the method of producing a molded product in the present disclosure.
Fig. 14 illustrates a perspective view of an example of a microfluidic device obtained by the method of producing a molded product in the present disclosure.
Fig. 15 illustrates a perspective view of an example of a prism sheet obtained by the method of producing a molded product in the present disclosure.

### DESCRIPTION OF EMBODIMENTS

An example of embodiments of some aspects in the present invention will be described in detail below.

In the present disclosures, each numerical range specified using "(from) ... to ..." represents a range including the numerical values noted before and after "to" as the minimum value and the maximum value, respectively. The same or corresponding member in each drawing is denoted by the same reference character.

### <Method 1 of Producing Molded Product>

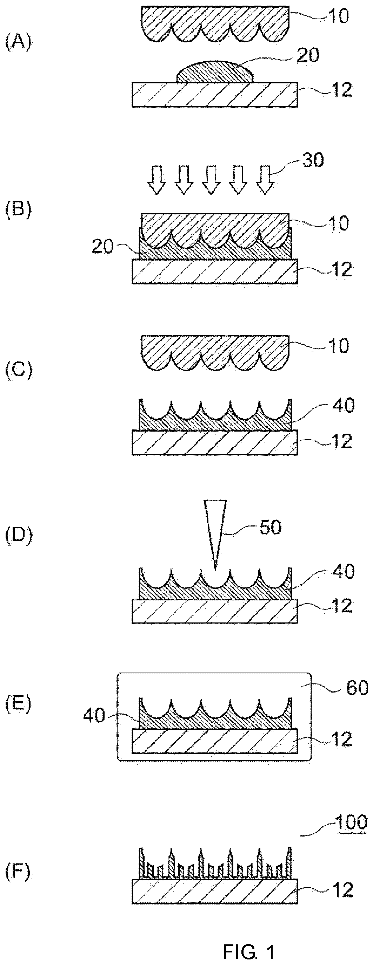

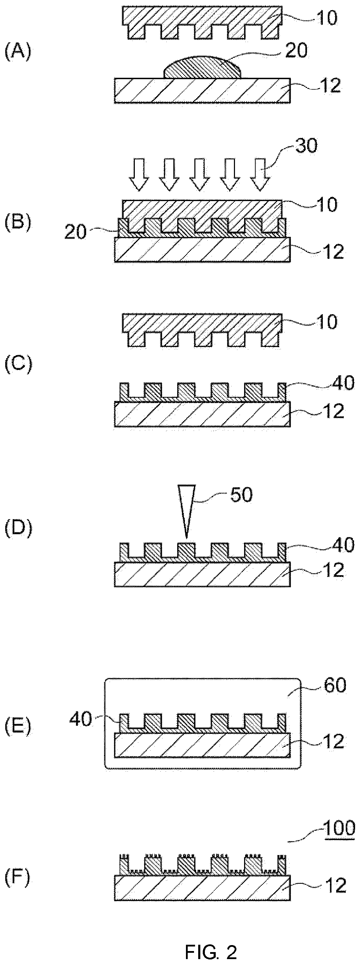

Each of Figs. 1 and 2 illustrates an example of a method 1 of producing a molded product (hereinafter may be abbreviated as "production method 1"), and a method of producing a molded product of some aspects in the present invention is not limited thereto.

The method 1 of producing a molded product 100 includes:
pressing a mold 10 having a surface including at least one of a concave part or a convex part against a photocurable positive electron beam resist (hereinafter may be abbreviated as "resist") 20 (hereinafter also referred to as "pressing process", Fig. 1(A) and Fig. 2(A));
obtaining a molded product of the positive electron beam resist (hereinafter also referred to as "imprint-molded product") 40 having a surface including a concave part and a convex part by irradiating the photocurable positive electron beam resist 20 pressed with the mold with light 30 to cure the resist (Fig. 1(B) and Fig. 2(B)) (hereinafter also referred to as "photo-curing process"); and
partially decomposing the molded product of the positive electron beam resist at a region subjected to irradiation with an electron beam by irradiating the surface of the imprint-molded product 40 with the electron beam 50 (Fig. 1(D) and Fig. 2(D)) (hereinafter also referred to as "electron beam irradiation process").

The method of producing the molded product 100 may further include another process.

In the method 1 of producing the molded product 100, the photocurable positive electron beam resist 20 is pressed against the mold 10, and photo-cured to form (imprinting) a concave-convex part on the surface of the cured resist product, and then the surface with the concave-convex part is irradiated with the electron beam 50. In other words, electron beam lithography is directly performed on a pattern molded by the imprinting to additionally process a pattern.

In the producing method 1 in the present disclosure, the imprint-molded product 40 is cleaved to form a positive pattern in a region irradiated with the electron beam 50, and therefore, a resist for electron beam lithography need not be additionally applied onto the imprint-molded pattern. Therefore, in the producing method 1 in the present disclosure, a 3D hybrid pattern can be produced in processes fewer than those in a conventional method, and a higher throughput can be achieved.

In the producing method 1 in the present disclosure, since it is not necessary to additionally apply a resist for electron beam lithography other than the photocurable resist for imprinting, it is possible to integrally form a molded product having a hybrid pattern. Therefore, there is no interface in the molded product, and the molded product may be preferably applied to an optical member.

In addition, the molded product obtained in the producing method 1 in the present disclosure may also be used as a mold for imprinting. The use of the molded product as the mold for imprinting enables a molded product having a 3D hybrid pattern to be produced with a higher throughput.

Fig. 2 differs from Fig. 1 in view of the different surface geometry of the mold 10, and the other processes are similar. As described above, hybrid patterns having various geometries and sizes can be formed by exchanging a mold for imprinting in the producing method 1 in the present disclosure.

Each process in the method 1 of producing a molded product will be described below.

### (Pressing Process)

In the pressing process, the mold 10 having a surface including at least one of a concave part or a convex part against a resist 20 (Fig. 1(A) and Fig. 2(A));

Examples of the material of the mold 10 include: carbon materials such as graphite (C), and a complex of graphite and a carbon nanotube; semiconductive materials such as monocrystalline silicon (Si), polysilicon (a-Si), silicon carbide (SiC), and silicon nitride (SiN); and metal materials such as nickel (Ni), aluminum (Al), tungsten (W), tantalum (Ta), and copper (Cu). Dielectric materials such as ceramic, and optical materials such as quartz and soda glass are also acceptable.

The mold 10 may be a replica mold which is copied from a master mold. The replica mold may be made of a material that is the same as or different from that of the master mold.

For example, the replica mold may be produced using a resin composition for a replica mold. Examples of the resin composition for a replica mold include negative photoresists, and the replica mold may be produced by transferring the master mold using by a UV-NIL (UV-nanoimprint lithography) method. The negative photoresist may be based on a (meth)acrylic resin or an epoxy resin.

Such negative photoresists based on epoxy resins are commercially available products such as, for example, trade names: SU-8 3005, SU-8 3010, SU-8 3025, SU-8 3035, and SU-8 3050 (of which all are manufactured by Nippon Kayaku Co., Ltd.).

The resin used for a replica mold may be a methacrylate compound such as an epoxy ester from the viewpoint of enhancing the flexibility of the replica mold to suppress occurrence of mold release failure. Examples of the epoxy ester may include a compound represented by the following general formula (1).

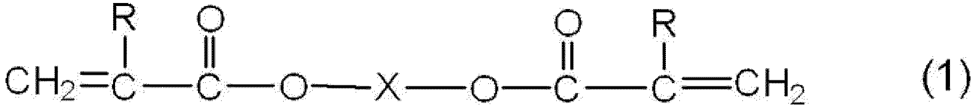

In the formula (1), each R independently represents a hydrogen atom or a methyl group, and X represents a divalent group including a (poly)alkyleneoxy group.

The divalent group including a (poly)alkyleneoxy group represented by X in the formula (1) may be a monoalkyleneoxy group, which includes one alkyleneoxy group, or a polyalkyleneoxy group, which includes two or more alkyleneoxy groups. The number of the alkyleneoxy groups in X is not limited. Examples of the (poly)alkyleneoxy group include a (poly)ethyleneoxy group and a (poly)propyleneoxy group.

The divalent group including a (poly)alkyleneoxy group represented by X in the formula (1) may include an additional group other than a (poly)alkyleneoxy group. Examples of the additional group may include a bisphenol group.

The divalent group including a (poly)alkyleneoxy group represented by X in the formula (1) may have a substituent. Examples of the substituent may include a hydroxyl group.

Among compounds represented by the general formula (1), examples of a compound (epoxy ester) in which X is a divalent group including an alkyleneoxy group may include the following compounds.

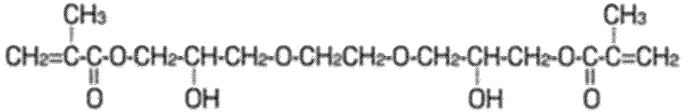

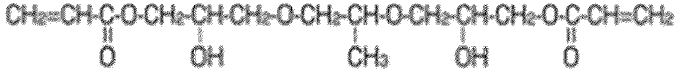

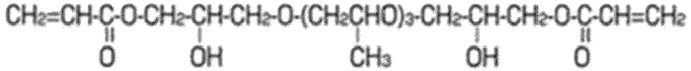

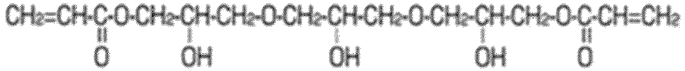

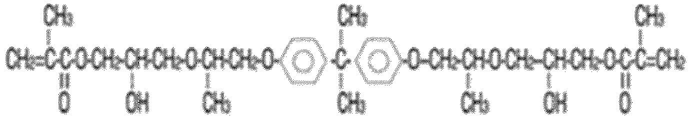

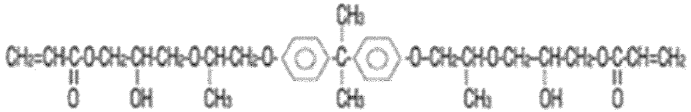

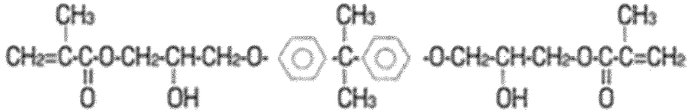

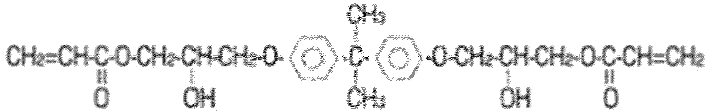

Commercially available products of the epoxy ester are available as, for example, trade names of Kyoeisha Chemical Co., Ltd: EPOXY ESTER M-600A, EPOXY ESTER 40EM, EPOXY ESTER 70PA, EPOXY ESTER 200PA, EPOXY ESTER 80MFA, EPOXY ESTER 3002M (N), EPOXY ESTER 3002A (N), EPOXY ESTER 3000MK, and EPOXY ESTER 3000A.

It is preferable that the material of the mold 10 transmit light having a wavelength used for curing when the resist 20 is irradiated with light through the mold 10 to be cured in a later photo-curing process.

At least a part of a concave part or a convex part of the mold 10 may have a diameter or width in a range of from 1 µm to 5 mm at least one portion thereof. The concave part or the convex part of the mold 10 may have nano-order (from 1 nm to 99 nm) diameter or width, milli-order (from 1 mm to 5 mm) diameter or width, submicron-order (from 100 µm to 999 µm) diameter or width, or micron-order (from 1 µm to 99 µm) diameters or widths at least one portion thereof.

A ratio (aspect ratio) of a height to a diameter of each concave part or convex part of the mold 10 may be not limited, and the aspect ratio may be 2 or more. The aspect ratio may be appropriately designed depending on the application of the molded product 100.

The geometries of the concave part or the convex part of the mold 10 are not particularly limited. For example, as illustrated in Fig. 1, the geometry of a protrusion may be hemispheric in a cross-sectional view, and conversely, the geometry of a gap portion may be hemispheric. As illustrated in Fig. 2, the geometry of a protrusion may be rectangular in a cross-sectional view. In a cross-sectional view, the geometry of a protrusion may be a triangular or multistage geometry, which is not illustrated.

A mold release agent may be applied to the mold 10 to perform mold release treatment. The mold release treatment facilitates to release the mold 10 from the imprint-molded product 40. A commonly known mold release agent may be used as the mold release agent, and examples of the mold release agent include fluorine compounds, silane coupling agents, and surfactants.

A resist which is photocurable, and in which a polymer after photo-curing the resist can be cleaved by irradiation with an electron beam is used as the resist 20.

Commonly, a photocurable resist is a negative resist. In contrast, commonly, a resist which can be cleaved by irradiation with an electron beam is a positive resist. As described above, commonly, when a photocurable resist is irradiated with an electron beam, polymerization of the photocurable resist further proceeds, and therefore, the photocurable resist is not cleaved. Meanwhile, commonly, the resist which can be cleaved by irradiation with an electron beam is irradiated with light, the resist is not cured and is unable to be imprinted.

Against such contradictory characteristics as described above, the resist 20 applicable in the producing method 1 in the present disclosure can be obtained, for example, in the following manner.

First, a monomer to constitute a polymer that can be cleaved by irradiation with an electron beam is selected as a positive electron beam resist. The monomer to constitute the polymer is polymerized at a reduced polymerization degree so as to have a photo-curing ability, and all or a part of the monomer are polymerized to be a prepolymer which may be used as the resist. The prepolymer may be obtained by subjecting the monomer to heat treatment or light irradiation treatment to partially polymerize the monomer.

Such prepolymer is polymerized at a reduced polymerization degree, and therefore, irradiation of the prepolymer with light allows polymerization reaction to proceed, whereby the prepolymer is cured and becomes a polymer. The photo-cured polymer becomes a polymer that can be cleaved by irradiation with an electron beam. In other words, it is preferable that the imprint-molded product 40 obtained after photo-curing the resist 20 include a polymer, and the main chain of the polymer can be cleaved by irradiation with an electron beam.

The positive electron beam resist may be a mixture of the prepolymer and the monomer. When the positive electron beam resist is a mixture of the prepolymer and the monomer, a content rate of the monomer in the positive electron beam resist can be appropriately designed. For example, in a case of producing a molded product having a thin-film shape, the molded product preferably includes a larger amount of a monomer having a smaller molecular weight. In contrast, a smaller content rate of the monomer is preferred from the viewpoint of improvement in photo-curability in imprinting.

The resist 20 preferably includes a functional group that is radically polymerizable or cationically polymerizable by irradiation with light, more preferably includes a functional group that is radically polymerizable by irradiation with light, and still more preferably includes at least one prepolymer and/or monomer selected from the group consisting of a (meth)acrylic compound and a styrenic compound. The functional group that is radically polymerizable by irradiation with light remains in the prepolymer and/or monomer.

In the resist 20, a compound included in a non-chemical amplification type resist may be selected as a kind of the monomer. The non-chemical amplification type resist is a monomer that is radically polymerizable, and examples thereof include an α-substituted acrylate or an α-substituted styrene, which has an alkyl group, a halogen atom, or an halogenated alkyl group at the α-position. It is difficult to cleave a polymer of an acrylate or a styrene having a hydrogen at the α-position by irradiation with an electron beam, whereas a polymer of the α-substituted acrylate or the α-substituted styrene can be cleaved by irradiation with an electron beam.

Examples of the α-substituted acrylate include compounds represented by the following general formula (2), and examples of the α-substituted styrene include compounds represented by the following general formula (3).

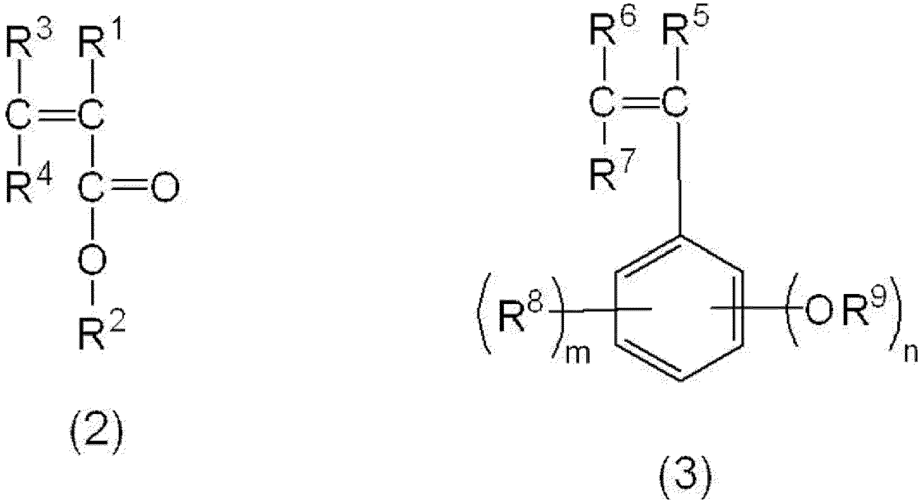

In the formula (2), R¹ represents an alkyl group, a halogen atom, or a halogenated alkyl group. R² represents a linear, branched or cyclic alkyl group, an alkyl group in which at least one of methylene group in the alkyl group is substituted with a divalent hetero atom-containing group, an aryl group, or a heteroaryl group, and these groups may have a substituent.

The substituent and the hetero atom-containing group will be described later.

Each of R³ and R⁴ independently represents a hydrogen atom, an alkyl group, a halogen atom, or a halogenated alkyl group.

In the formula (3), R⁵ represents an alkyl group, a halogen atom, or a halogenated alkyl group. Each of R⁶ and R⁷ independently represents a hydrogen atom, an alkyl group, a halogen atom, or a halogenated alkyl group. R⁸ represents an alkyl group, a halogen atom, or a halogenated alkyl group. R⁹ represents a hydrogen atom, an alkyl group, or a halogenated alkyl group. Each of m and n independently represents an integer from 0 to 5, and m + n is from 0 to 5.

The halogen atom represented by R¹, R³, R⁴, R⁵, R⁶, R⁷, and R⁸ is preferably a chlorine atom or a fluorine atom. The halogen atom in the halogenated alkyl group represented by R¹ to R⁹ is preferably a fluorine atom. The alkyl group represented by R¹ to R⁹ preferably has a carbon number of from 1 to 5, more preferably a methyl group or an ethyl group, and still more preferably a methyl group.

Specific examples of the compounds represented by the general formula (2) include methyl methacrylate (MMA), ethyl methacrylate, n-butyl methacrylate, tert-butyl methacrylate, n-hexyl methacrylate, 2-ethylhexyl methacrylate, n-stearyl methacrylate, methoxypolyethylene glycol methacrylate, methoxyethyl methacrylate, tetrahydrofurfuryl methacrylate, benzyl methacrylate, phenoxyethyl methacrylate, isobornyl methacrylate, 2-hydroxyethyl methacrylate, 2-hydroxypropyl methacrylate, dimethylaminoethyl methacrylate, 2-methacryloyloxyethyl succinate, glycidyl methacrylate, 2-methacryloyloxyethyl acid phosphate, dicyclopentanyl methacrylate, cyclohexyl methacrylate, 1-adamantyl methacrylate, 2-methyl-2-adamantyl methacrylate, 3-hydroxy-1-adamantyl methacrylate, γ-butyrolactone methacrylate, 3,3,4,4,5,5,6,6,7,7,8,8-tridecafluoro-n-octyl methacrylate, methyl α-fluoroacrylate, ethyl α-fluoroacrylate, methyl α-trifluoromethylacrylate, ethyl α-trifluoromethylacrylate, 2,2,2-trifluoroethyl α-fluoroacrylate, 2,2,3,3,3-pentafluoropropyl α-fluoroacrylate, 2-(perfluorobutyl)ethyl α-fluoroacrylate, 2-(perfluorohexyl)ethyl α-fluoroacrylate, 1H,1H,3H-tetrafluoropropyl α-fluoroacrylate, 1H,1H,5H-octafluoropentyl α-fluoroacrylate, 1H,1H,7H-dodecafluoroheptyl α-fluoroacrylate, 1H-1-(trifluoromethyl)trifluoroethyl α-fluoroacrylate, 1H,1H,3H-hexafluorobutyl α-fluoroacrylate, and 1,2,2,2-tetrafluoro-1-(trifluoromethyl)ethyl α-fluoroacrylate.

From the viewpoint of a cleavage property caused by irradiation with an electron beam, R¹ in the formula (2) is preferably a chlorine atom, a fluorine atom, or a fluorinated alkyl group having from 1 to 5 carbon atoms, more preferably a chlorine atom, a fluorine atom, or a perfluoro methyl group, and still more preferably a chlorine atom or a fluorine atom. From the viewpoint of availability, R¹ in the formula (2) is preferably an alkyl group.

From the viewpoint of a cleavage property caused by irradiation with an electron beam, each of R⁸ in the formula (3) preferably independently represents an alkyl group, and more preferably an alkyl group having from 1 to 5 carbon atoms. From the viewpoint of a cleavage property caused by irradiation with an electron beam, each of R⁹ in the formula (3) preferably independently represents a hydrogen atom or an alkyl group, more preferably a hydrogen atom or an alkyl group having from 1 to 5 carbon atoms, and still more preferably a hydrogen atom.

From the viewpoint of a cleavage property caused by irradiation with an electron beam, in the formula (3), m is preferably 0, and n is preferably 0.

Specific examples of the compounds represented by the general formula (3) include α-methylstyrene and derivatives thereof represented as follows, and α-methylstyrene is preferred from the viewpoint of the easiness of preparation of a polymer and a cleavage property caused by irradiation with an electron beam.

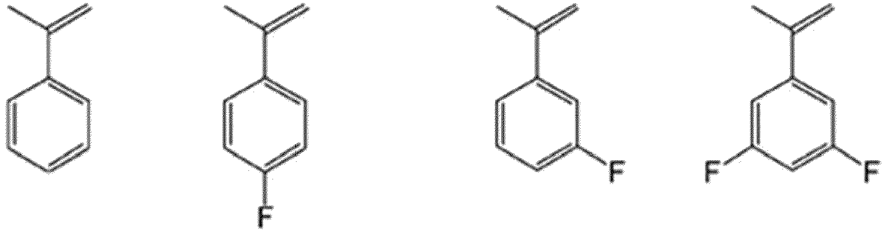

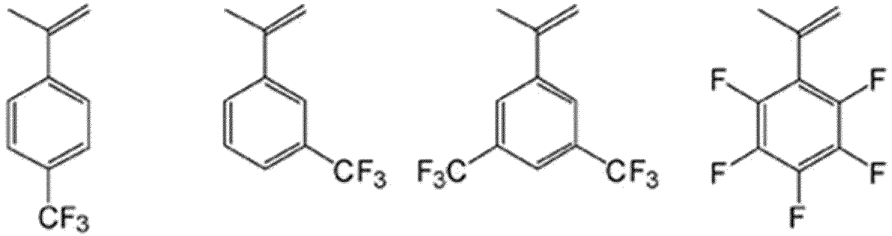

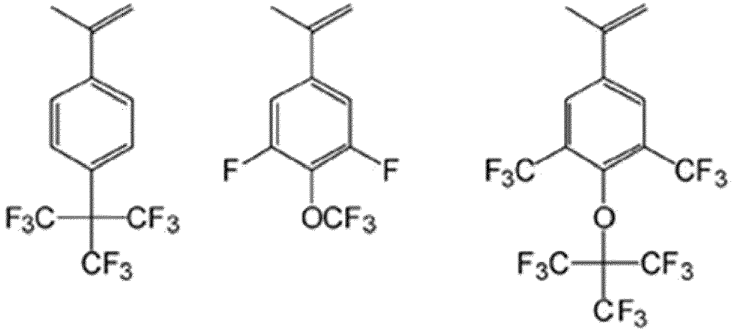

The prepolymer may be a homopolymer polymerized using at least one selected from the group consisting of the compounds represented by the general formula (2) and the compounds represented by the general formula (3), or may be a precopolymer polymerized in combination of two or more thereof.

The prepolymer may be a copolymer in which another first monomer that is copolymerizable with the compounds represented by the general formula (2) and the compounds represented by the general formula (3) is combined with the compounds in addition to the compounds. It is preferable to use another first monomer in an amount within a range that another first monomer does not inhibit cleavage by irradiation with an electron beam.

The resist may include another second monomer other than the prepolymer, the precopolymer, and the monomer. A content of another second monomer in the resist is preferably from 0.5% by mass to 20% by mass.

It is preferable that the prepolymer be produced by bulk polymerization without use of a solvent from the viewpoint of suppressing the generation of bubbles.

It is preferable that a polymerization initiator be used for polymerization for preparing the prepolymer. The polymerization initiator may be a thermal polymerization initiator or a photopolymerization initiator. It is preferable to use the photopolymerization initiator when the photopolymerization initiator is also used in polymerization reaction in the later photo-curing process.

The photopolymerization initiator may be a radical polymerization initiator, a cationic-polymerization initiator, or an anionic-polymerization initiator. Examples of the radical polymerization initiator include at least one of a radical polymerization initiator having a carbon atom, an oxygen atom and a hydrogen atom, or a radical polymerization initiator having a carbon atom, a nitrogen atom, an oxygen atom and a hydrogen atom. Specific examples thereof include at least one selected from the group consisting of 2-benzyl-2-dimethylamino-1-(4-morpholinophenyl)-butan-1-one, 2-(dimethylamino)-2-[(4-methylphenyl)methyl]-1-[4-(4-morpholinyl)phenyl]-1-butanone, 2-hydroxy-1-{4-[4-(2-hydroxy-2-methyl-propionyl)-benzyl]phenyl}-2-methyl-propan-1-one, 1-hydroxy-cyclohexyl-phenyl-ketone, 2,2-dimethoxy-1,2-diphenylethan-1-one, 2-hydroxy-2-methyl-1-phenyl-propan-1-one, 1-[4-(2-hydroxyethoxy)-phenyl]-2-hydroxy-2-methyl-1-propan-1-one, phenyl glyoxylic acid methyl ester, acetophenone, p-anisil, benzil, benzoin, and benzophenone.

A content of the photopolymerization initiator can be appropriately designed according to the kind and amount of the monomer. For example, a content rate of the photopolymerization initiator is preferably 0.05% by mass or more, more preferably 0.5% by mass or more, and still more preferably 10% by mass or less with respect to a total amount of the monomer and the photopolymerization initiator. The content rate of the photopolymerization initiator is more preferably from 1% by mass to 4% by mass, and still more preferably from 1.5% by mass to 3.5% by mass.

When it is difficult to mix the polymerization initiator with the monomer, it is preferable that a container including the polymerization initiator and the monomer be placed in warm water, and the polymerization initiator and the monomer be further stirred with ultrasonic waves. It is also acceptable to alternately repeatedly place the container including the polymerization initiator and the monomer in warm water and stir the polymerization initiator and the monomer with ultrasonic waves. A temperature of the warm water is appropriately set depending on the kinds of the polymerization initiator and the monomer.

A wavelength of light used for forming the prepolymer using the photopolymerization initiator is preferably selected appropriately depending on the kind of the photopolymerization initiator, and the like. An irradiation time for the polymerization is preferably set appropriately depending on the kind of the monomer, the wavelength of light, the kind of the polymerization initiator, and the like. An irradiation dose for the polymerization is preferably set appropriately depending on the amount and kind of the monomer, the wavelength of light, the amount and kind of the polymerization initiator, and the like, more preferably from 0.1 J/cm² to 500 J/cm², and may be, for example, from 1 J/cm² to 100 J/cm².

When the prepolymer is formed by using the photopolymerization initiator, it is preferable to store the prepolymer in a cool and dark space after polymerization reaction so that the reaction stops at an appropriate polymerization degree. A storage temperature is preferably -20°C or lower.

Common examples of imprinting methods include a method using a thermoplastic resin and a method using a photo-curable resist. Since the photo-curable resist is applied to a mold in a monomer state, the molecular weight of the photo-curable resist when the photo-curable resist is applied to the mold is considerably less than that of a thermoplastic resin, and the photo-curable resist can enter the narrow gaps of the mold, thus the method using the photo-curable resist has excellent transferability. The resist 20 in the present disclosure may be formed into a prepolymer; however, the molecular weight of the resist 20 is less than that of a thermoplastic resin since the reaction is stopped at an appropriate polymerization degree. Therefore, the resist 20 in the present disclosure is superior to the thermoplastic resin in transferability of imprinting.

When the resist 20 is allowed to contain a prepolymer, the prepolymer may be synthesized in advance and prepared as a resist component, or a part or all of monomers in the resist containing the monomers may be formed into the prepolymer to allow the prepolymer to be contained in the resist.

The monomer may also be used as the resist. The resist may include only the monomer, and it is preferable to allow the resist to contain the prepolymer from the viewpoint of usability. When the resist includes the prepolymer, a weight-average molecular weight of the resist is preferably from 500 to 150000, and more preferably from 1000 to 80000. A number-average molecular weight (Mn) of the resist is preferably from 500 to 120000, and more preferably from 800 to 60000. A dispersion degree (Mw/Mn) of the resist is preferably from 1 to 50, and more preferably from 1 to 25.

The weight-average molecular weight of the resist when the resist contains the prepolymer indicates a value in terms of standard polystyrene molecular weight, measured by gel permeation chromatography (GPC). In order to adjust the weight-average molecular weight of the resist within the aforementioned range, the prepolymer may be allowed to be contained in the resist appropriately, or polymerization conditions under which the resist is formed into the prepolymer may be set as described above.

The resist 20 may include an additional component other than the prepolymer and the monomer. Examples of the additional component include sensitizers, dispersants, antifoaming agents, plasticizers, surfactants, mold release agents, fillers, polymerization inhibitors, polymerization retarders, ultraviolet absorbents, and heat/light stabilizers. Not only one prepolymer but also a plurality of prepolymers may be used.

A content of the monomer blended in the resist 20 is preferably 5% by mass or more, and more preferably 30% by mass or more. The content is preferably 100% by mass or less.

The prepolymer may be used as a polymer generating a difference in chemical property by irradiation with a second energy ray. The polymer generating a difference in chemical property by irradiation with a second energy ray may be a polymer obtained by polymerizing the monomer used in the resist, or may be a polymer obtained by polymerizing a monomer used in an imprint material described later. In other words, the resist 20 may include a component polymerized in advance, and a component in which a part of monomers in the resist are polymerized may be allowed to present in a process in the method of producing a molded product, specifically before the pressing process.

A polymer synthesized by a common polymerization method may be used as the polymer generating a difference in chemical property by irradiation with a second energy ray.

A viscosity of the resist 20 is preferably from 10 mPa·s to 20000 mPa·s, more preferably from 50 mPa·s to 15000 mPa·s, and still more preferably from 60 mPa·s to 5000 mPa·s from the viewpoint of applicability and handleability.

A viscosity of a composition refers to a value measured in conformity with JIS Z8803:2011.

A curing time (a period of time from beginning of irradiation with light to sufficient curing) of the resist 20 is preferably 60 minutes or less, preferably 10 minutes or less, and still more preferably 60 seconds or less.

The mold 10 is pressed against the prepared resist 20 (Fig. 1(A)). The concave-convex pattern of the mold 10 is transferred to the resist 20 by pressing the mold 10.

It is acceptable to apply the resist 20 to a substrate 12, followed by pressing the mold 10 against the resist 20, as illustrated in Fig. 1(A), or it is also acceptable to apply the resist 20 to the mold 10, followed by pressing the mold 10 against the substrate 12.

Furthermore, it is also acceptable to prepare another mold 14 different from the mold 10, and to apply the resist 20 to the mold 10, followed by pressing the mold 10 against the mold 14. In this method, the resist 20 presents between the mold 10 and the mold 14, and therefore, a concave-convex geometry resulting from the mold 10 is formed on one surface of the resist 20 while a concave-convex geometry resulting from the mold 14 is formed on the other surface thereof.

For example, when using both the molds 10 and 14 having curved recess on surfaces thereof, the obtained imprint-molded product 40 has a lens geometry having curved projection on both the surfaces thereof. When using both the molds 10 and 14 having curved projection on surfaces thereof, the obtained imprint-molded product 40 has a lens geometry having curved recess on both the surfaces thereof.

A method of applying the resist 20 to the substrate 12 or the mold 10 is not particularly limited, and a commonly used method may be used as the method. Examples thereof include a printing method such as a screen printing method and a gravure printing method, a brush painting method, a doctor blade method, and a roll coating method. A method capable of continuous application is preferable from the viewpoint of a larger area.

A pressing method is not particularly limited, and examples thereof include a method in which the substrate 12 and the mold 10 are simply pressed against each other, and a method in which a layered body of the substrate 12 and the mold 10 is sandwiched between two flat plates, and pressed.

A pressing force is preferably from 100 kPa to 50 MPa, and more preferably from 1 MPa to 10 MPa.

When the pressing force is 100 kPa or more, it is easy to introduce the resist 20 to the leading ends of the concave-convex parts of the mold 10. Meanwhile, when the pressing force is 50 MPa or less, a damage to the mold 10 tends to be suppressed.

Pressing time is preferably from 10 seconds to 1 hour, and more preferably from 3 minutes to 10 minutes.

When the pressing time is 10 seconds or more, it is easy to introduce the resist 20 to the leading ends of the concave-convex parts of the mold 10. Meanwhile, when the pressing time is 1 hour or less, an excessive drying of the resist 20 and the deterioration of flowability tend to be suppressed.

### (Photo-curing Process)

In the photo-curing process, the resist 20 pressed by the mold 10 is irradiated with light 30 to cure the resist 20 (Fig. 1(B) and Fig. 2(B)). The irradiation with light causes the resist 20 to become the imprint-molded product 40. A concave part and a convex part are formed on a surface of the obtained imprint-molded product 40.

A light irradiation condition may be appropriately set depending on the kind and amount of photo-curable resin used, and further on the kind of the photopolymerization initiator when using the photopolymerization initiator. Specifically, light having a wavelength of from an ultraviolet region to a blue region may be used. An illuminance may be, for example, from 100 lx to 500 lx. The illuminance is preferably from 1 mW/cm² to 5000 mW/cm², and more preferably from 5 mW/cm² to 500 mW/cm². A light exposure dose is preferably from 100 mJ/cm² to 300000 mJ/cm², and more preferably from 1000 mJ/cm² to 200000 mJ/cm², and may be, for example, from 1000 mJ/cm² to 5000 mJ/cm².

The imprint-molded product obtained in the photo-curing process preferably has a weight-average molecular weight (Mw) of from 1000 to 500000, more preferably from 2000 to 200000, and still more preferably from 5000 to 100000, and preferably has a number-average molecular weight (Mn) of from 500 to 300000, more preferably from 1000 to 200000, and still more preferably from 2000 to 100000, and preferably has a dispersion degree (Mw/Mn) of from 1 to 50, and more preferably from 1 to 25.

The weight-average molecular weight of the imprint-molded product indicates a value in terms of standard polystyrene molecular weight, measured by gel permeation chromatography (GPC). In order to adjust the weight-average molecular weight of the imprint-molded product within a range as described above, light irradiation conditions are set as described above.

A glass transition point of the imprint-molded product obtained in the photo-curing process is preferably not less than room temperature (for example, 25°C), more preferably from room temperature (for example, 25°C) to 300°C, and still more preferably from room temperature (for example, 25°C) to 150°C.

When the mold 10 is composed of a material that transmits the irradiation light, it is preferable to perform the irradiation with light through the mold 10. When the substrate 12 is composed of a material that transmits the irradiation light, the irradiation with light may be performed through the substrate 12. When the mold 14 is used and the mold 14 is composed of a material that transmits the irradiation light, the irradiation with light may be performed through the mold 14.

When the light is irradiated through the mold 10 or 14, the mold 10 or 14 is removed from the imprint-molded product 40 after the photo-curing process (Fig. 1(C) and Fig. 2(C)).

When the resist 20 or the imprint-molded product 40 remains on a surface of the removed mold 10 or 14, the removed mold 10 or 14 can be reused by removing the remaining resist 20 or imprint-molded product 40. Examples of a method of removing the resist 20 and the imprint-molded product 40 from the mold 10 or 14 include a method in which the mold 10 or 14 is immersed in a solvent, whereby a polymer in the resist 20 and the imprint-molded product 40 is dissolved. It is preferable that the mold 10 or 14 after the immersion in the solvent be dried to remove the solvent.

Before the subsequent electron beam irradiation process (Fig. 1(D) and Fig. 2(D)), the imprint-molded product 40 may be washed (not illustrated) and dried (not illustrated), if necessary.

### (Electron Beam Irradiation Process)

In the electron beam irradiation process, the surface of the imprint-molded product 40 is irradiated with an electron beam 50 (Fig. 1(D) and Fig. 2(D)). The imprint-molded product 40 in an irradiation region is partially decomposed by the irradiation with the electron beam 50. Accordingly, development in a later process removes the region irradiated with the electron beam to form at least one of a groove (blind hole) or a through-hole. A depth of a pattern formed by the removal can be adjusted by changing an irradiation dose or acceleration voltage of the electron beam.

Irradiation conditions of the electron beam 50 can be appropriately selected. For example, the acceleration voltage may be set at from 5 kV to 100 kV The higher acceleration voltage enables formation of the pattern having a smaller line width and a higher aspect ratio. A current value may be from 5 pA to 100 pA. The irradiation dose may be, for example, from 1 µC/cm² to 5000 µC/cm².

After the irradiation with the electron beam 50, development with a liquid developer 60 (Fig. 1(E) and Fig. 2(E)) removes the irradiation region of the molded product of the positive electron beam resist to allow an unirradiation region to remain, and thereby, a molded product 100 having a 3D hybrid pattern on a surface thereof is obtained (Fig. 1(F) and Fig. 2(F)).

The liquid developer 60 is not particularly limited as long as being a solvent. For example, a fluorine-based solvent, an alcohol, an acetic acid ester having an alkyl group, or a mixture thereof may be used as the liquid developer 60. Examples of the fluorine-based solvent may include CF₃CFHCFHCF₂CF₃, CF₃CF₂CHCl₂, CClF₂CF₂CHClF, CF₃CF₂CF₂CF₂OCH₃, and C₈F₁₈. Examples of the alcohol may include methanol, ethanol, 1-propanol, and 2-propanol (isopropyl alcohol). Examples of the acetic acid ester having an alkyl group may include amyl acetate and hexyl acetate.

After the development, rinsing may be performed with a rinsing liquid (not illustrated). The rinsing liquid is not particularly limited, but may be appropriately selected depending on the kind of the liquid developer used.

In accordance with the producing method 1 in the present disclosure, the width of a pattern generated by the electron beam 50 can be less than the widths of at least one of the concave part or the convex part formed by the imprinting, and a 3D hybrid pattern can be formed on a surface of the molded product.

### <Molded Product Obtained by Producing Method 1>

A 3D hybrid pattern including a pattern formed by imprinting and a pattern formed by electron beam lithography are formed on at least a part of a surface of the molded product 100.

The width of a pattern generated by the electron beam 50 can be less than the widths of at least one of the concave part or the convex part formed by pressing the mold 10.

At least a part of the concave part or the convex part formed by the imprinting may have diameters or widths of from 1 µm to 5 mm, or may have nano-order (from 1 nm to 99 nm), milli-order (from 1 mm to 5 mm), submicron-order (from 100 µm to 999 µm) or micron-order (from 1 µm to 99 µm) diameters or widths. A ratio (aspect ratio) of the depth or height to the diameter or width of each concave part or convex part formed by imprinting may be not limited, and may be 2 or more.

At least a part of the pattern formed by the electron beam lithography may have a width or diameter in a range of from 10 nm to 800 nm.

From the viewpoint of efficiently producing a hybrid pattern, it is preferable that a pattern having a size of micron order or more be produced by the imprinting, and a pattern having a nano-order size be produced by the electron beam lithography.

The molded product 100 can have 3D hybrid patterns having various geometries and sizes. Therefore, the molded product 100 may be applied to various applications such as microfluidic devices, antireflective structures, and water-repellent structures.

### <Method 2 of Producing Molded Product>

Examples of embodiments of a method of producing a molded product according to some aspects in the present invention include the following method (hereinafter may be abbreviated as "producing method 2") as well as the method 1 of producing a molded product described above.

The producing method 2 is a method of producing a molded product, the method including:
a process (a) of preparing a mold having a surface including at least one of a first concave part or a first convex part, and an imprint material;
a process (b) of generating a bond between a plurality of molecules included in the imprint material and converting the imprint material into a first film having at least one of a second concave part or a second convex part by subjecting the imprint material to at least one of irradiation with a first energy ray or heat treatment in a state in which the imprint material is in contact with at least a part of at least one of the first concave part or the first convex part;
a process (c) of generating a difference in a physical or chemical property between a first portion of the first film, the first portion being irradiated with a second energy ray, and a second portion other than the first portion by irradiating the first film with the second energy ray; and
a process (d) of forming a molded product in which a structure including at least one of a third concave part or a third convex part is applied to the first film by removing either the first portion or the second portion.

In the producing method 2, the formation of the first film in the process (b) is performed in the following manner. The first film is formed by subjecting the imprint material to at least one of the irradiation with the first energy ray or the heat treatment in a state in which the imprint material is in contact with at least one of the first concave part or the first convex part, thereby converting the imprint material into the first film. At least one of the second concave part or the second convex part is formed (imprinted) on a surface of the obtained first film. Then, the first portion including at least one of the second concave part or the second convex part is irradiated with the second energy ray, to remove either the first portion or the second portion, whereby a pattern is additionally formed. In other words, the first film having the pattern formed by the imprinting is directly irradiated with the second energy ray, to further additionally process the pattern.

The producing method 2 includes the scope described in the producing method 1. With regard to the producing method 2, some embodiments other than the scope described in the producing method 1 will be described below.

### (Process (a))

The first film formed in the process (a) is obtained by generation of bonding between the plurality of molecules included in the imprint material. More specifically, the first film includes a polymer obtained by polymerizing the imprint material. The polymer may be a cross-linked body that is cross-linked. The polymer may include both of a cross-linked body that is cross-linked and a polymer that is not cross-linked. Hereinafter, "polymer" means "polymer and/or cross-linked body".

A mold similar to the mold in the producing method 1 may be used as the mold.

An imprint material, in which a polymer is obtained by generation of bonding between a plurality of molecules by at least one of the irradiation with the first energy ray or the heat treatment, and in which bonding or cleaving a part of the polymer is induced by the irradiation with the second energy ray, is used as the imprint material. "Imprint material" includes "photocurable positive electron beam resist" described in the producing method 1.

A resist including a thermal radical polymerization initiator instead of the photo-radical polymerization initiator in the positive electron beam resist in the producing method 1 may be used when the first film in the process (b) is obtained by the heat treatment. A common thermal radical polymerization initiator may be used as the thermal radical polymerization initiator. Examples of the thermal polymerization initiator include peroxides, azo compounds, azide compounds, and diazo compounds, and specific examples thereof include at least one selected from the group consisting of benzoyl peroxide, t-butyl-peroxybenzoate, azobisisobutyronitrile, azidobenzaldehyde, azidobenzalmethylcyclohexanones, azobis compounds such as azobisisobutyronitrile and dimethyl-2,2'-azobis(2-methylpropionate), aromatic diazonium salts, and naphthoquinonediazide compounds.

In the positive electron beam resist in the producing method 1, a cationic polymerization initiator may be used instead of the photo-radical polymerization initiator. Examples of the cationic polymerization initiator include: protonic acids such as hydrochloric acid, sulfuric acid, perchloric acid, trifluoroacetic acid, methanesulfonic acid, trifluoromethanesulfonic acid, chlorosulfonic acid, and fluorosulfonic acid; Lewis acids such as boron trifluoride, aluminum chloride, titanium tetrachloride, stannic chloride, and ferric chloride; and UV-sensitive photo-acid generators.

In the positive electron beam resist in the producing method 1, an anionic polymerization initiator may be used instead of the photo-radical polymerization initiator. Examples of the anionic polymerization initiator include: organic alkali metals such as methyllithium, n-butyllithium, sec-butyllithium, and t-butyllithium; organic alkali earth metals such as methylmagnesium chloride and methylmagnesium bromide; alkali metals such as lithium, sodium, and potassium; and UV-sensitive photo-base generators.

The imprint material includes at least one compound having at least one selected from the group consisting of a substituent that is radically polymerizable, a substituent that is cationically polymerizable and a substituent that is anionically polymerizable by performing at least one of the irradiation with the first energy ray or the heat treatment.

Examples of the compound having a substituent that is radically polymerizable include the monomer that is radically polymerizable used in the positive electron beam resist in the producing method 1.

Examples of the compound having a substituent that is cationically polymerizable include a common monomer that is cationically polymerizable.

Examples of the compound having a substituent that is anionically polymerizable include a common monomer that is anionically polymerizable.

In addition, the following composition may be used as the imprint material.
(1) A composition for an imprint material, including: a compound containing an acid-reactive group; a photopolymerization initiator or a thermal polymerization initiator; and a photo-acid generator having sensitivity to a second energy ray. It is preferable that the photopolymerization initiator or the thermal polymerization initiator be a photo-radical polymerization initiator or a thermal radical polymerization initiator, respectively.

In the composition for an imprint material, the monomer containing an acid-reactive group is polymerized or cross-linked with the photopolymerization initiator by the irradiation with the first energy ray, or polymerized or cross-linked with the thermal polymerization initiator by the heat treatment, in the process (b), whereby a polymer having an acid-reactive group is formed.

Then, the polymer is irradiated with the second energy ray in the process (c), whereby the photo-acid generator is decomposed to generate an acid, and the acid causes conversion of the polarity of the acid-reactive group of the polymer having the acid-reactive group, thereby generating a difference in a chemical property between the first portion and the second portion.

Examples of the acid-reactive group include an acid-dissociable group that is decomposed by action of an acid to generate a carboxylic acid, a phenolic hydroxyl group, or the like. Specific examples of the acid-dissociable group include a group represented by the following formula (a-1) or (a-2), or the like. Examples of the compound containing the acid-dissociable group include a compound in which R² in the formula (2) is a group represented by the following formula (a-1) or (a-2), or the like.

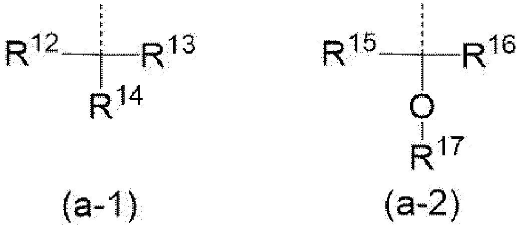

In the formula (a-1), each of R¹² and R¹³ independently represents a linear, branched or cyclic alkyl group, and examples thereof include an alkyl group such as methyl, ethyl, n-propyl, n-butyl, isopropyl, t-butyl, a cyclopropyl group, a cyclobutyl group, a cyclopentyl group, a cyclohexyl group, an adamantan-1-yl group, an adamantan-2-yl group, a norbornan-1-yl group, and a norbornan-2-yl group.

R¹⁴ represents a linear, branched or cyclic alkyl group that may have a substituent, the alkyl group is selected from the same option as each of the alkyl groups as R¹², and a part of the hydrogen atoms thereof may be substituted with a hydroxyl group, an alkoxy group, an oxo group, an amino group, an alkylamino group, or the like. The R¹², R¹³, and R¹⁴ may form a ring structure directly by a single bond, or via a methylene group.

In the formula (a-2), each of R¹⁵ and R¹⁶ independently represents a hydrogen atom, or a linear, branched or cyclic alkyl group, and the alkyl group is selected from the same option as each of the alkyl groups as R¹².

R¹⁷ is a linear, branched or cyclic alkyl group that may have a substituent, the alkyl group is selected from the same option as each of the alkyl groups as R¹², and a part of the hydrogen atoms thereof may be substituted with a hydroxyl group, an alkoxy group, an oxo group, an amino group, an alkylamino group, or the like. The R¹⁵, R¹⁶, and R¹⁷ may form a ring structure directly by a single bond, or via a methylene group.

Specific examples of the formulae (a-1) and (a-2) may include structures described below. However, the present invention is not limited thereto.

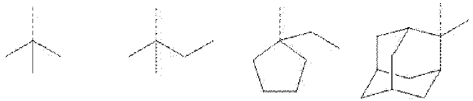

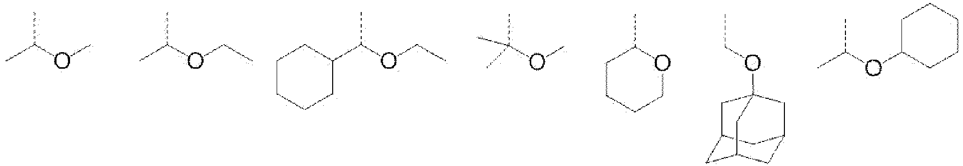

The composition for an imprint material may include another compound other than the compound containing an acid-reactive group, from the viewpoint of improvement in adhesiveness and improvement in strength. Examples of another compound include a compound represented by the following formula (4a) or (4b). When the composition for an imprint material includes the following compound as well as the compound containing an acid-reactive group, the polymer may be a copolymer.

A content of the compound containing an acid-reactive group in the composition for an imprint material is preferably from 1% by mass to 100% by mass, more preferably from 10% by mass to 90% by mass, and still more preferably from 30% by mass to 80% by mass.

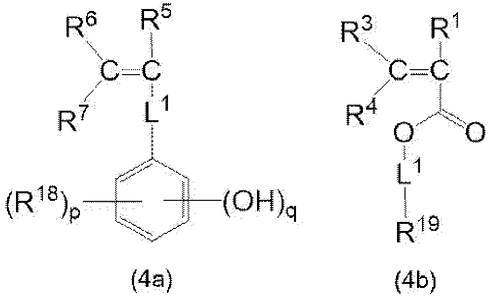

Each of R¹ and R³ to R⁷ in the formulae (4a) and (4b) is independently selected from the same option as each of R¹ and R³ to R⁷ in the formulae (2) and (3).

L¹ represents any one selected from the group consisting of a direct bond, a carbonyloxy group, a carbonylamino group, a linear, branched or cyclic alkylenecarbonyloxy group that may have a substituent, and an alkylenecarbonylamino group.

Each of R¹⁸ independently represents any one selected from the group consisting of an alkyl group, a hydroxy group, an alkoxy group, an alkylcarbonyl group, an alkylsulfanyl group, an alkylsulfinyl group, an alkyl sulfonyl group, an amino group, a cyano group, a nitro group, and a halogen atom.

R¹⁹ is a cyclic group including at least one selected from the group consisting of -C(O)-O-, -SO₂-, and -O-SO₂-. Examples of the cyclic group include a group containing a lactone skeleton, a sultone skeleton, and a sulfolane skeleton.

In addition, p is an integer from 0 to 4, and q is an integer from 1 to 5.

The acid-reactive group may be an acid-crosslinkable group that is polymerizable by action of an acid. Specific examples of the acid-crosslinkable group include an epoxy group, a vinyloxy group, and an oxetanyl group. Examples of the compound containing an acid-crosslinkable group include a compound in which R² in the formula (2) is the acid-crosslinkable group.

The photopolymerization initiator or thermal polymerization initiator included in the positive electron beam resist used in the producing method 1 may be used as the photopolymerization initiator or thermal polymerization initiator in the composition for an imprint material.

For example, a photo-acid generator commonly used in an ArF resist or an EUV resist may be used as the photo-acid generator in the composition for an imprint material. Specifically, a photo-acid generator disclosed in JP-ANo. 2003-342254, International Publication No. WO 2011/93139, International Publication No. WO 2016/88648, JP-ANo. 2016-212241, or the like may be used as the photo-acid generator.

More specific examples thereof include an onium salt represented by the following general formula (5) or (6).

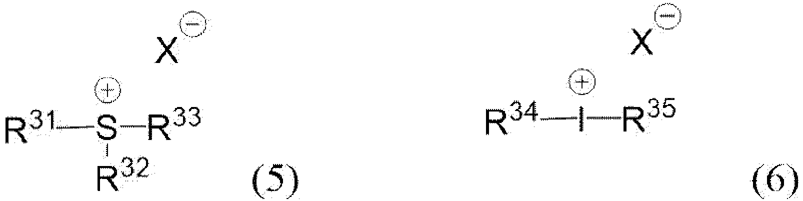

Each of R³¹ to R³³ in the general formula (5) independently represents any one of a linear, branched, monocyclic or bridged cyclic alkyl group, an aryl group, and a heteroaryl group. These may have a substituent. Two or more of R³¹ to R³³ may form a ring structure by a single bond, or via any one selected from the group consisting of an oxygen atom, a sulfur atom, a nitrogen-containing group, and a methylene group, together with a sulfur atom to which they are bound.

At least one methylene group in the R³¹ to R³³ may be substituted with a divalent hetero atom-containing group. At least one methylene group in the R³¹ to R³³ may be substituted with a carbon-carbon double bond.

Examples of the hetero atom-containing group include -O-, -CO-, -COO-, -OCO-, -O-CO-O-, -NHCO-, -CONH-, -NH-CO-O-, -O-CO-NH-, -NH-, -N(R)-, -N(Ar)-, -S-, -SO-, and -SO₂-.

Examples of the substituent may include, but are not limited to, a hydroxy group, a cyano group, a mercapto group, a carboxy group, a carbonyl group, an alkyl group (-R), an alkoxy group (-OR), an acyl group (-COR), an alkoxycarbonyl group (-COOR), an aryl group (-Ar), an aryloxy group (-OAr), an amino group, an alkylamino group (-NHR), a dialkylamino group (-N(R)₂), an arylamino group (-NHAr), a diarylamino group (-N(Ar)₂), an N-alkyl-N-arylamino group (-NRAr) a phosphino group, a silyl group, a halogen atom, a trialkylsilyl group (-Si-(R)₃), a silyl group in which at least one of alkyl groups of the trialkylsilyl group is substituted with Ar, an alkylsulfanyl group (-SR), and an arylsulfanyl group (-SAr).

The aforementioned hetero atom-containing group is also used as the hetero atom-containing of R² in the formula (2) in the method 1 of producing a molded product.

R in the substituent or the like is preferably an alkyl group having a number of carbon atoms of 1 or more, and more preferably 20 or less. Specific preferred examples of the alkyl group having a number of carbon atoms of 1 or more include: linear alkyl groups such as a methyl group, an ethyl group, an n-propyl group, an n-butyl group, an n-pentyl group, an n-hexyl group, an n-octyl group, and an n-decyl group; branched alkyl groups such as an isopropyl group, an isobutyl group, a tert-butyl group, an isopentyl group, a tert-pentyl group, and a 2-ethylhexyl group; alicyclic alkyl groups such as a cyclopropyl group, a cyclobutyl group, a cyclopentyl group, a cyclohexyl group, an adamantan-1-yl group, an adamantan-2-yl group, a norboman-1-yl group, and a norbornan-2-yl group; a silyl group-substituted alkyl group in which one of hydrogen atoms thereof is substituted with a trialkylsilyl group such as a trimethylsilyl group, a triethylsilyl group and a dimethylethylsilyl group; and an alkyl group in which at least one of hydrogen atoms thereof is substituted with a cyano group, a fluoro group or the like. A carbon-carbon single bond in the alkyl group may be replaced by a carbon-carbon double bond.

The aforementioned substituent is also used as the substituent of R² of the formula (2) in the method 1 of producing a molded product.

Ar in the substituent or the like is preferably an aryl group or a heteroaryl group. The heteroaryl group is an aryl group including one or more hetero atoms in the ring structure. Specific preferred examples of the Ar include those having a number of carbon atoms of 20 or less, such as a phenyl group, a biphenyl group, a terphenyl group, a quaterphenyl group, a naphthyl group, an anthryl group, a phenanthrenyl group, a pentalenyl group, an indenyl group, an indacenyl group, an acenaphthyl group, a fluorenyl group, a heptalenyl group, a naphthacenyl group, a pyrenyl group, a chrysenyl group, a tetracenyl group, a furanyl group, a thienyl group, a pyranyl group, a sulfanylpyranyl group, a pyrrolyl group, an imidazoyl group, an oxazolyl group, a thiazolyl group, a pyrazoyl group, and a pyridyl group, an isobenzofuranyl group, a benzofuranyl group, an isochromenyl group, a chromenyl group, an indolyl group, an isoindolyl group, a benzimidazoyl group, a xanthenyl group, an aquadinyl group, and a carbazoyl group.

The photo-acid generator in the composition for an imprint material may be a compound bound to the R² moiety of the formula (2). The onium salt represented by the general formula (5) or (6) is a monocation, and may be a dication.

When R³¹ to R³³ have the substituent, and the onium salt is a low-molecular-weight compound, a number of carbon atoms of each of R³¹ to R³³ is preferably from 1 to 30, including a number of carbon atoms of the substituent.

X⁻ is a counter anion. The counter anion is not particularly limited, and examples thereof include anions such as a sulfonate anion, a carboxylate anion, an imide anion, a methide anion, a carbo anion, a borate anion, a halogen anion, a phosphate anion, an antimonate anion, and an arsenate anion.

The imprint material may include an additional component, as well as the compound containing an acid-reactive group, the photopolymerization initiator or the thermal polymerization initiator, and the photo-acid generator. Examples of the additional component include sensitizers, dispersants, antifoaming agents, plasticizers, surfactants, mold release agents, fillers, polymerization inhibitors, polymerization retarders, ultraviolet absorbents, and heat/light stabilizers. Not only one compound containing an acid-reactive group but also a plurality of compounds containing an acid-reactive group may be used. The compound containing an acid-reactive group may be a monomer or a prepolymer.

An amount of the monomer in the imprint material is preferably 5% by mass or more, and more preferably 30% by mass or more. The amount is preferably 100% by mass or less.

### (Process (b))

In the process (b), the imprint material is allowed to be in the state of being in contact with the mold having at least one of the concave part or the convex part on a surface thereof. At least one of the concave part or the convex part of the mold may be allowed to be in contact with the imprint material. It is also preferable to press the mold against the imprint material in a manner similar to the producing method 1. The imprint material is converted into a first film having at least one of a second concave part or a second convex part by subjecting the imprint material to at least one of irradiation with a first energy ray or heat treatment in a state in which the imprint material is in contact with the mold having at least one of the concave part or the convex part on the surface thereof.

Examples of the first energy ray include the light in the producing method 1. Specific examples of the light include, but are not limited to, light having a wavelength of 250 nm or more.

The first film in the process (b) includes a polymer obtained by polymerizing or cross-linking the imprint material. The concave and convex parts of the mold having at least one of the first concave part or the first convex part are transferred to the first film, whereby the first film has at least one of the second concave part or the second convex part.

The irradiation with the first energy in the process (b) may be performed in a manner similar to the photo-curing process of the producing method 1.

Conditions of the heat treatment in the process (b) may be appropriately set depending on the kind, amount, film thickness and the like of the imprint material used. Specifically, the heat treatment may be performed by heating at from 30°C to 250°C for from 10 seconds to 60 minutes.

In the process (b), both the irradiation with the first energy and the heat treatment may be performed.

In a manner similar to the producing method 1, an imprint material made into a prepolymer before the irradiation with the first energy ray or the heat treatment may be used as the imprint material.

### (Process (c))

In the process (c), the phrase "generating a difference in a chemical property between a first portion of the first film, the first portion being irradiated with the second energy ray, and a second portion other than the first portion by irradiating the first film with the second energy ray" refers to the conversion of the polarity of the first film, caused by decomposing (cleaving) the main chain or a part of a polymer included in the first film due to the irradiation with the second energy ray. Bonding of the acid-reactive groups of the polymer included in the first film due to the irradiation with the second energy ray also results in the conversion of the polarity of the first film, and therefore the bonding enables generation of a difference in a chemical property between the second portion and the first portion.

In the process (c), the phrase "generating a difference in a physical property between a first portion of the first film, the first portion being irradiated with the second energy ray, and a second portion other than the first portion by irradiating the first film with the second energy ray" refers to physical change caused by, e.g., melting or sublimation of the polymer due to the irradiation with the second energy ray.

An irradiation angle of the second energy ray is preferably at least one angle in a range of from 0 to 90° with respect to a normal line to a surface of the first film. The more preferred irradiation angle of the second energy ray is from 0 to 30° with respect to the normal line to the surface of the first film.

The phrase "surface of first film" refers to the same plane as a surface of the imprint material prior to the formation of at least one of the second concave part or the second convex part.

It is preferable that an energy of the second energy ray be greater than that of the first energy ray. For example, when light having a wavelength of 400 nm or more is used as the first energy ray, light having a wavelength of less than 400 nm may be used as the second energy ray.

Specific examples of the second energy ray include far-ultraviolet rays such as a KrF excimer laser, an ArF excimer laser, an F₂ excimer laser, and an EUV, and a X-ray, as well as the electron beam in the producing method 1.

### (Process (d))

Examples of removing either the first portion or the second portion in the process (d) include development with the liquid developer described in the producing method 1. Examples of a method of the development include an alkali development and an organic solvent development. Typically, a positive resist pattern is formed by the alkali development, and a negative resist pattern is formed by the organic solvent development.

In addition to the liquid developer mentioned in the producing method 1, an alkaline liquid developer commonly used in a chemical amplification resist or the like can also be used as the liquid developer.

In a case of the alkali development, examples thereof include an alkaline aqueous solution in which at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene, and 1,5-diazabicyclo-[4.3.0]-5-nonene is dissolved. Of these, the TMAH aqueous solution is preferred.

In a case of the organic solvent development, examples thereof include a liquid containing, as a main component, an organic solvent such as a hydrocarbon solvent, an aromatic solvent, a ketone solvent, an alcoholic solvent, an amide solvent, an ether solvent, and an ester solvent.

### <Molded Product Obtained by Producing Method 2>

The molded product obtained by the producing method 2 preferably includes a 3D hybrid pattern including a pattern formed by the imprinting and a pattern formed in the processes (c) and (d) on at least a part of the surface thereof. However, two or more patterns having different geometries and sizes may be present on different surfaces rather than on one surface. The molded product obtained by the producing method 2 is preferably a mold having two or more concave-convex patterns.

Similar to the producing method 1, a width of the pattern formed in the processes (c) and (d) may be smaller than the widths of at least one of the concave part or the convex part formed by pressing the mold. Herein, "width" is a distance in a direction orthogonal to the longitudinal direction of at least one of the concave part or the convex part when the concave part and the convex part has a rectangular shape such as a line pattern.

However, the concave part and the convex part may have not only rectangular shapes but also dot shapes and indefinite shapes. In such a case, the sizes of at least one of the concave part or the convex part formed by pressing the mold are preferably different from the sizes of the concave part or the convex part of the pattern formed in the processes (c) and (d). For example, the sizes of at least one of the concave part or the convex part of the pattern formed in the processes (c) and (d) may be smaller than the sizes of at least one of the concave part or the convex part formed by pressing the mold, and the sizes of at least one of the concave part or the convex part of the pattern formed in the processes (c) and (d) may be larger than the sizes of at least one of the concave part or the convex part formed by pressing the mold.

At least a part of the concave part or the convex part formed by the imprinting may have sizes such as a diameter or a width of from 1 µm to 5 mm, or may have nano-order (from 1 nm to 99 nm), milli-order (from 1 mm to 5 mm), submicron-order (from 100 µm to 999 µm), or micron-order (from 1 µm to 99 µm) sizes. A ratio (aspect ratio) of a depth or height to a size such as the diameter or width of the concave part or convex part formed by the imprinting may be not limited, and may be 2 or more.

At least a part of the pattern formed by the processes (c) and (d) may have a size such as a width or a diameter in a range of from 10 nm to 800 nm.

From the viewpoint of efficiently producing a hybrid pattern, it is preferable that a pattern having a size of micron order or more be produced by the imprinting, and a pattern having a nano-order size be produced by the irradiation with the second energy ray.

The molded product can have 3D hybrid patterns having various geometries and sizes. Therefore, the molded product can be applied to various applications such as microfluidic devices, and articles having antireflective structures, water-repellent structures and the like.

### <Method of Producing Replica Mold>

A method of producing a replica mold in the present disclosure includes: preparing the mold obtained in the producing method 2, and a resin composition for a replica mold; and obtaining a replica mold by transferring the two or more concave-convex patterns of the mold to the resin composition for a replica mold, and by curing the resin composition. The details of the mold and the resin composition for a replica mold is as described in the method 1 of producing a molded product in the present disclosure, described above.

### <Resist for Collective Molding with Imprint-Electron Beam Lithography>

In the method of producing a molded product in the present disclosure, a resist for imprinting and a resist for electron beam lithography are not separately used, but one resist is used to perform collective molding. The resist for collective molding with imprint-electron beam lithography includes a prepolymer including a functional group that is polymerizable by light irradiation, in which a main chain of a polymer obtained after irradiating the prepolymer with light is decomposable by irradiation with an electron beam. The details of the resist are as described in the methods 1 and 2 of producing a molded product in the present disclosure, described above.

### <Imprint Material>

An imprint material in the present disclosure includes a monomer including a functional group that is polymerizable by at least one of irradiation with the first energy ray or heat treatment, and a main chain or a part of a polymer obtained after subjecting the monomer to heating or irradiation with light is decomposable or cross-linkable by irradiation with the second energy ray. The details of the monomer including a functional group that is polymerizable and the polymer obtained after subjecting the monomer to heating or irradiation with light are as described in the method 2 of producing a molded product in the present disclosure, described above.

### <Article Having Hybrid Pattern on Surface>

In accordance with a method of producing a molded product in one aspect in the present invention, an article having a hybrid pattern on a surface thereof can be produced.

Examples of the article having a hybrid pattern on a surface thereof include the following articles:
optical elements: microlens arrays, optical waveguide elements, diffraction gratings, light guide plates, prism sheets, and the like;
antireflective members: optical films, light dispersing films, non-reflection films, and the like;
chips: microfluidic devices, biochips, microreactor chips, and the like; and
semiconductors: LEDs, power semiconductors, image sensors, and the like.

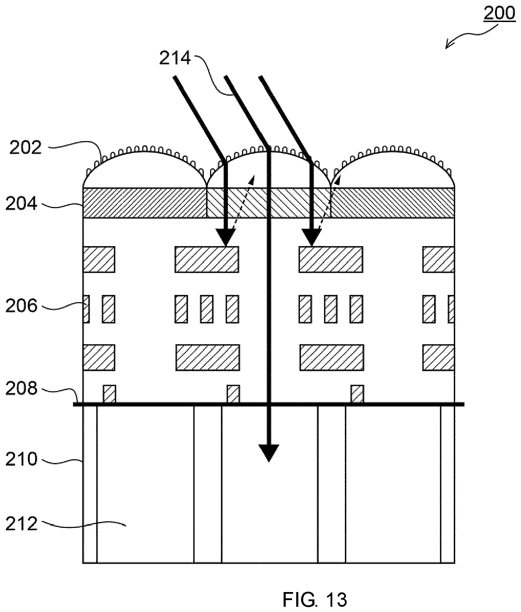

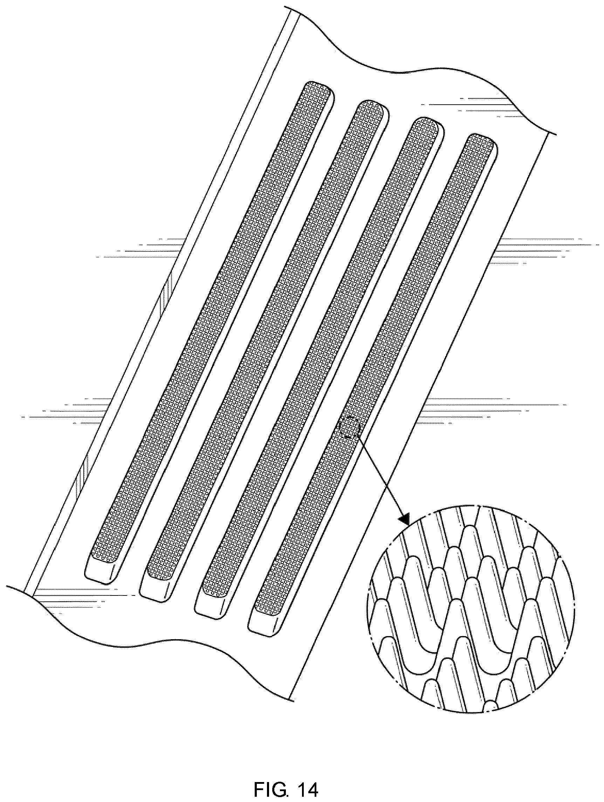

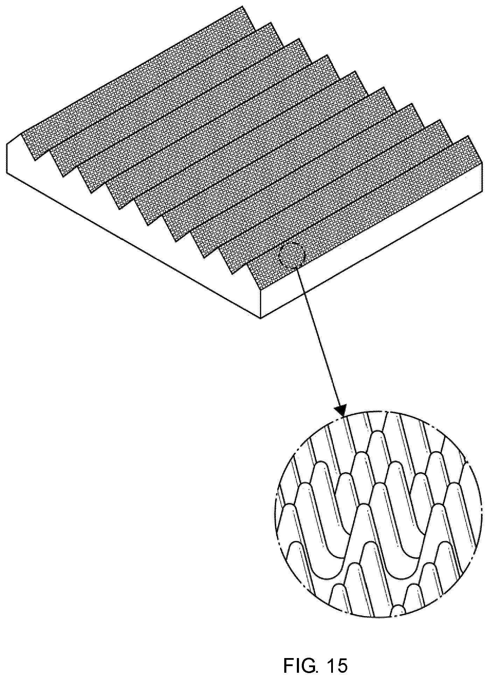

More specific examples of the article having a hybrid pattern on a surface thereof include image sensors, microfluidic devices, and prism sheets, as illustrated in Figs. 13 to 15.

### <Method of Producing Device>

A method of producing a device in the present disclosure includes: preparing a mold obtained by the producing method 2 or a replica mold obtained by the method of producing a replica mold; and transferring the two or more concave-convex patterns of the mold or the replica mold to a resin composition for transfer, and curing the resin composition to form a pattern. A resin composition commonly used for configuring a device may be used as the resin composition for transfer.

### Examples

The present invention will be specifically described below with reference to Examples. However, the present invention is not limited to these Examples.

### [Example 1]

### 1. Preparation of Resist

A photopolymerization initiator (IRGACURE369, BASF Japan Ltd.) was dissolved in a methyl methacrylate (MMA) monomer so that a concentration of the photopolymerization initiator was 2.0% by mass. A mercury lamp having an optimized wavelength of 365 nm was used, a position of a light source was adjusted so that an illuminance was 80 lx, and the resultant solution was irradiated. The irradiation was stopped when achieving an irradiation time of 50 minutes and an irradiation dose of 48 J/cm², and the solution was left standing for 10 minutes in a dark place at -20°C to obtain a resist including a prepolymer.

### 2. UV-NIL

### 2-1. Imprinting with Mold 1

A transparent resin mold 1 having dot and line-and-space (L & S) patterns of from nano-order to micro-order was prepared. Line widths of the L & S of the mold 1 were from 1 µm to 10 µm, and diameters of the dots thereof were from 800 nm to 10 µm. A size of the pressing surface of the mold 1 was 10 mm per side, and all the patterns were placed in this area. All the patterns had a depth of 320 nm.

The mold 1 was subjected to mold release treatment. In the mold release treatment, first, the mold 1 was coated with platinum using a sputtering apparatus (ESC101, ELIONIX INC. Co., Ltd.). A mold release agent (product name: OPTOOL, manufactured by DAIKIN INDUSTRIES, LTD., containing 1% by mass of fluorine compound) was applied thereonto, the mold 1 was heated at 85°C for 2 hours, and then rinsed with water for 30 minutes.

A drop (approximately 30 µL) of the obtained resist was dropwise added onto a silicon substrate of 10 mm per side, the substrate was covered from above the resist with the mold 1 subjected to the mold release treatment, and a load of 200 N was applied using a ball screw type UV-NIL apparatus (MITSUI ELECTRIC CO., LTD.). A pressure applied to the silicon substrate was 2.4 MPa. The silicon substrate was left standing for 30 seconds in this state, and then irradiated for 10 minutes using a mercury lamp having an optimized wavelength of 365 nm at an illuminance of 200 lx. After the irradiation, the mold was removed to obtain an imprint-molded product.

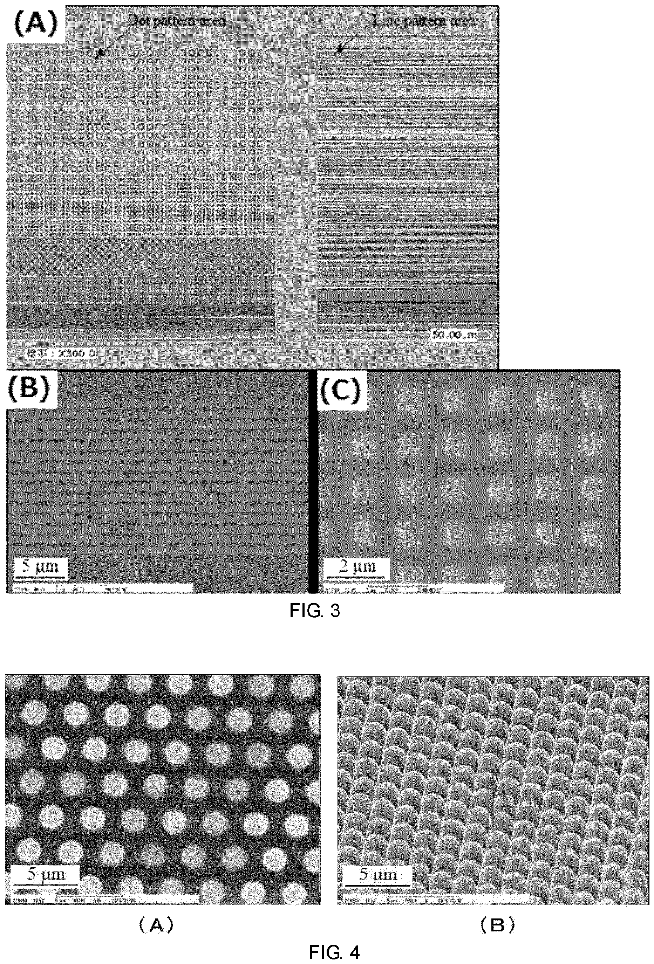

The imprint molded product was observed with a scanning electron microscope (SEM). Planar photographs thereof are illustrated in Fig. 3. Fig. 3(A) is a planar photograph with a magnification of 300 times, Fig. 3(B) is a planar photograph of the further enlarged portion of L & S, and Fig. 3(C) is a planar photograph of the further enlarged portion of the dot pattern. As illustrated in Fig. 3, the dot and L & S patterns of the mold were distinctly transferred.

### 2-2. Imprinting with Mold 2

Transferability was also confirmed in another mold 2. The mold 2 has a hole pattern having a diameter of 2 µm and a depth of 1 µm. The mold 2 was also subjected to mold release treatment similar to that in the mold 1. A transparent polyethylene film was used instead of the silicon substrate for the imprinting in a case of using the mold 1. Imprinting was performed under transfer conditions similar to those in the mold 1 except that the substrate was changed.

SEM images of the obtained imprint-molded product are illustrated in Fig. 4. Fig. 4(A) is a planar photograph, and Fig. 4(B) is a perspective photograph. Fig. 4 illustrates a scene in which a pillar pattern having an aspect ratio of 0.86 is formed and accurately transferred. After mold releasing, damage of the resist on the mold side was not observed.

### 2-3. Imprinting with Mold 3

Transferability was also confirmed in another mold 3. The mold 3 has an acicular pattern having a height of from around 500 nm to 800 nm. The mold 3 was also subjected to mold release treatment similar to that in the mold 1. Transfer conditions were similar to those in the mold 1.

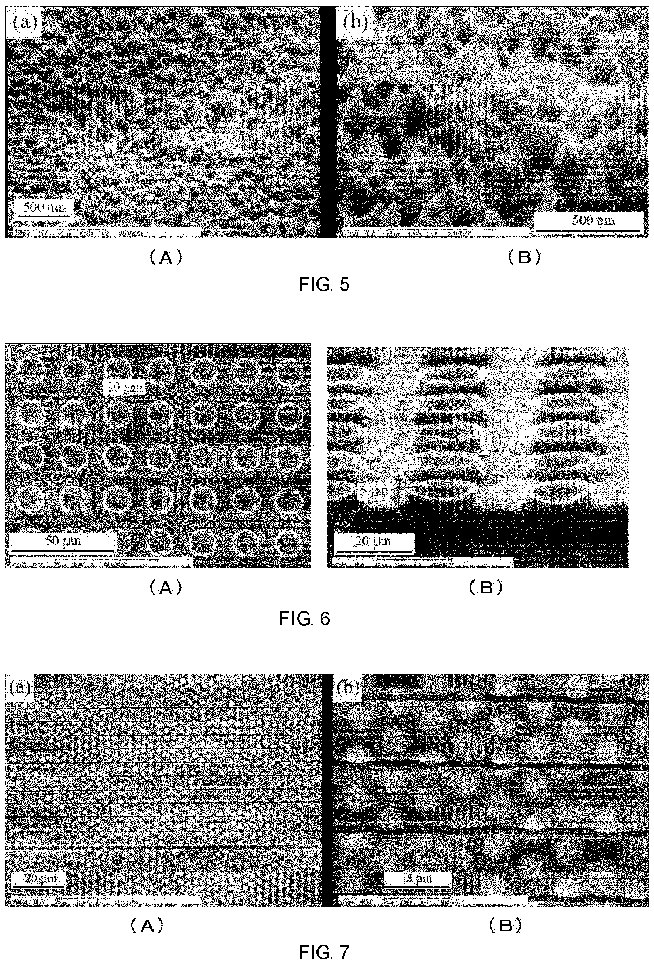

Perspective SEM images of an obtained imprint-molded product were illustrated in Fig. 5. Fig. 5(B) is a photograph of a further enlarged portion of Fig. 5(A). The photographs of Fig. 5 illustrate a scene in which an acicular pattern having a height of from 300 nm to 400 nm, including tip portions, is transferred.

### 2-4. Imprinting with Mold 4

Transferability was also confirmed in another mold 4. The mold 4 has a relatively large pattern regarding application of an imprinting method, having a diameter of 10 µm and a depth of from 8 µm to 10 µm. The mold 4 was also subjected to mold release treatment similar to that in the mold 1. Transfer conditions were similar to those in the mold 1.

SEM images of an obtained imprint-molded product are illustrated in Fig. 6. Fig. 6(A) is a planar photograph, illustrating that a pattern having a diameter of 10 µm is reproducibly transferred. No large defect of the pattern was seen in whole. Fig. 6(B) is a perspective photograph, illustrating that a pattern height is about 5 µm. The height of the pattern in the imprint-molded product is shortened by from around 40% to 50% than the mold depth of from 8 µm to 10 µm. This can be because the viscosity of the resist is high. Transfer of a pattern having a height of around 10 µm can be enabled by a longer filling time than that in the transfer conditions in a case of using the mold 2 having the pattern having a diameter of 2 µm.

### 3. Irradiation with Electron Beam

### 3-1. Electron Beam Lithography of L & S Pattern on Pillar Pattern

The pillar pattern with a diameter of 2 µm, produced using the mold 2, was irradiated with an electron beam. An SEM (ERA-8800FE: ELIONIX INC.), to which a lithography function was applied, was used for the irradiation with the electron beam. Irradiation conditions were set at an acceleration voltage of 10 kV, an irradiation dose of 500 µC/cm², and a current value of 10 pA, and the lithography of lines having the same width was performed at spacings of 5 µm.

The imprint-molded product irradiated with the electron beam was dipped in a commercially available liquid developer containing n-amyl acetate (ZED-N50, Zeon Corporation) for 30 seconds to be developed. After the development, the imprint-molded product was washed in such a manner that the imprint-molded product was washed away with pure water.

Planar SEM images of the pattern after the electron beam lithography are illustrated in Fig. 7. Fig. 7(B) is a photograph of a further enlarged Fig. 7(A). In Fig. 7(A), the lowest line is a marker, and therefore being thicker than the other patterns.

Fig. 7(B) illustrates that lithography of lines having a width of 490 nm is performed with favorable edges on the pillar pattern molded by the imprinting. The pillar pattern looks somewhat unclear in the photograph of Fig. 7(B) since photographing is performed with a focus on the lines. The edges of the lines by lithography were clear, and it was confirmed that additional positive processing from above the pattern can be performed by EB lithography.

### 3-2. Electron Beam Lithography of L & S Pattern on Hole Pattern

Although the lithography with the electron beam of 3-1 was conducted on the pillar, this lithography with the electron beam was also conducted on a hole pattern having a diameter of 2 µm, whose shape is reverse of the pillar. The lithography of the hole pattern was performed by changing the widths of the lines of the L & S pattern and by setting an irradiation dose at 200 µC/cm². Development conditions ware similar to the development conditions described above.

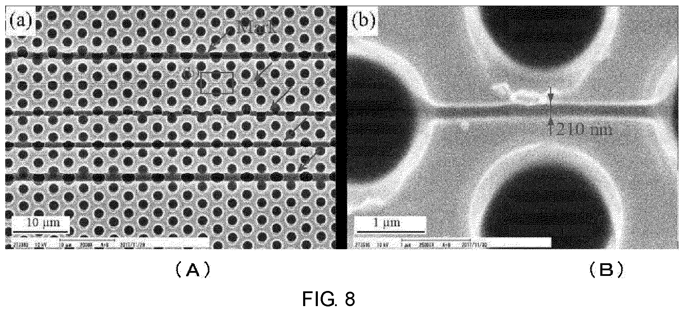

Planar SEM images of the pattern after the electron beam lithography are illustrated in Fig. 8. Fig. 8(B) is a photograph of a further enlarged Fig. 8(A).

Fig. 8 illustrates that the lithography of lines was also performed on the hole pattern molded by the imprinting. The minimum line width observed in Fig. 8(A) was 210 nm (see Fig. 8(B)).

### 3-3. Electron Beam Lithography of Dot Pattern on Pillar Pattern

In addition to the pattern lithography of the L & S of 3-1, lithography of a dot pattern was attempted. Hybrid patterns, in which lithography of dot patterns is performed on pillar patterns, are widely used in antireflective structures and water-repellent structures, and are practical geometries.

The lithography was performed on a pillar pattern having a diameter of 2 µm at an irradiation dose of 500 µC/cm² using an acceleration voltage of 10 kV. The liquid developer described above was used for development, and the development time was doubled to 60 seconds. This was because the larger volume of a portion to be developed than those in Figs. 7 and 8 was taken into consideration.

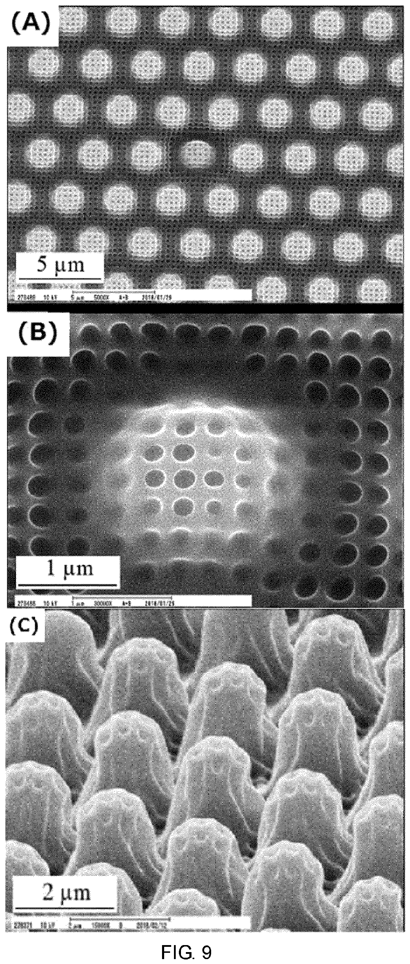

Planar SEM images of the pattern after the electron beam lithography are illustrated in Fig. 9. Fig. 9(B) is a photograph of a further enlarged Fig. 9(A), and Fig. 9(C) is a perspective photograph.

In Fig. 9(A), dots additionally processed with the electron beam are observed on the pillar pattern having a diameter of 2 µm and on a portion other than the pillar pattern. Fig. 9(B) illustrates that the dot forms a concave part having a diameter of 230 nm and a positive pattern is obtained.

In Fig. 9(C), holes (concave part) having a depth of around 100 nm on the apexes of the pillars are observed, and a scene in which side surfaces are dented so that portions irradiated with the electron beam are scraped out is observed.

Based on the results described above, the producing method in the present invention is found to be useful for processing a three-dimensional geometry in which micro-order and nano-order patterns are combined.

### [Example 2]

### <Production of Microlens Array Having Antireflective Structure>

A resist including the prepolymer synthesized in Example 1 was used. As a mold, a resin mold on which a plurality of convex lenses were arrayed was used. Imprinting was performed by a method similar to that of Example 1 except that the mold was changed. After the imprinting, irradiation with an electron beam was performed at an acceleration voltage of 20 kV, and development was performed. In the development, the same liquid developer as that in Example 1 was used, and development time was set at 60 seconds.

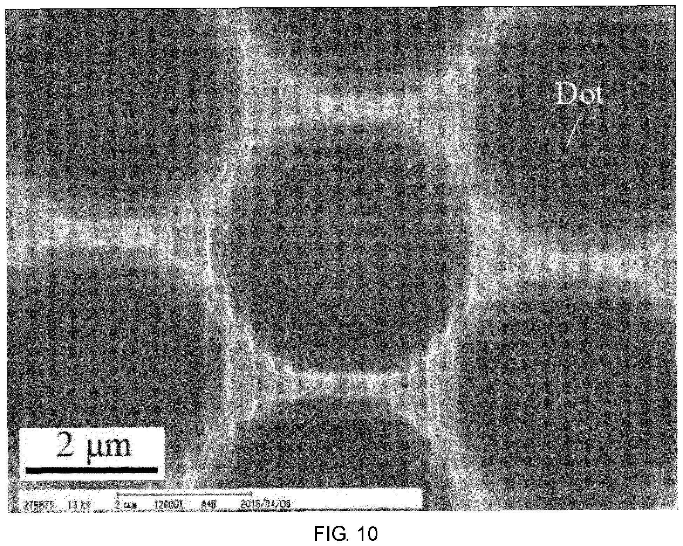

Fig. 10 is a planar SEM photograph of a molded product obtained in a case of setting the irradiation dose of the electron beam at 600 µC/cm². Fig. 10 illustrates that lithography of a dot pattern having a diameter of 200 nm was performed on the lenses having a diameter of 3.8 µm. The dot pattern portion was a positive pattern with recess.

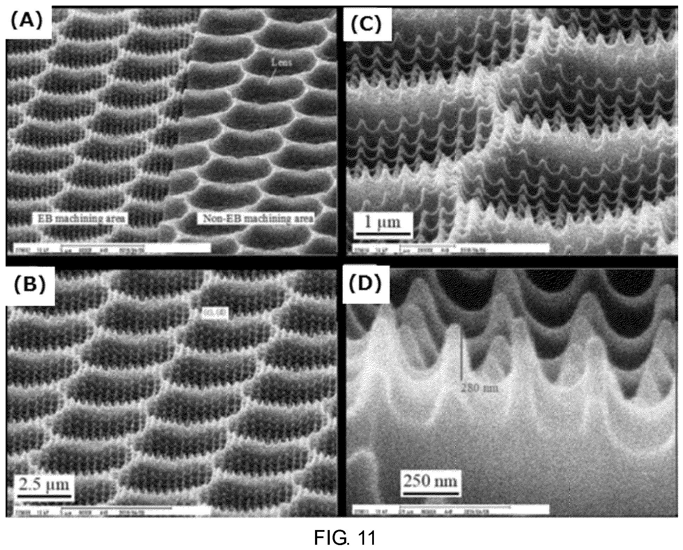

Fig. 11 illustrates perspective SEM photographs of a molded product obtained in a case of setting the irradiation dose of the electron beam at 1000 µC/cm². Fig. 11(A) is obtained by photographing a boundary between an electron beam-irradiated portion (left) and an electron beam-unirradiated portion (right). Fig. 11(C) is a photograph of an enlarged Fig. 11(B), and Fig. 11(D) is a photograph of a further enlarged Fig. 11(C).

It can be confirmed from Fig. 11(B) that a pattern having an aspect ratio of 1 or more is additionally processed on the concave lenses. Fig. 11(C) illustrates that the molded product has a hybrid structure including a micro-order pattern and a nano-order pattern. Fig. 11(D) illustrates that the heights of portions processed by the irradiation with the electron beam are from 300 nm to 500 nm.

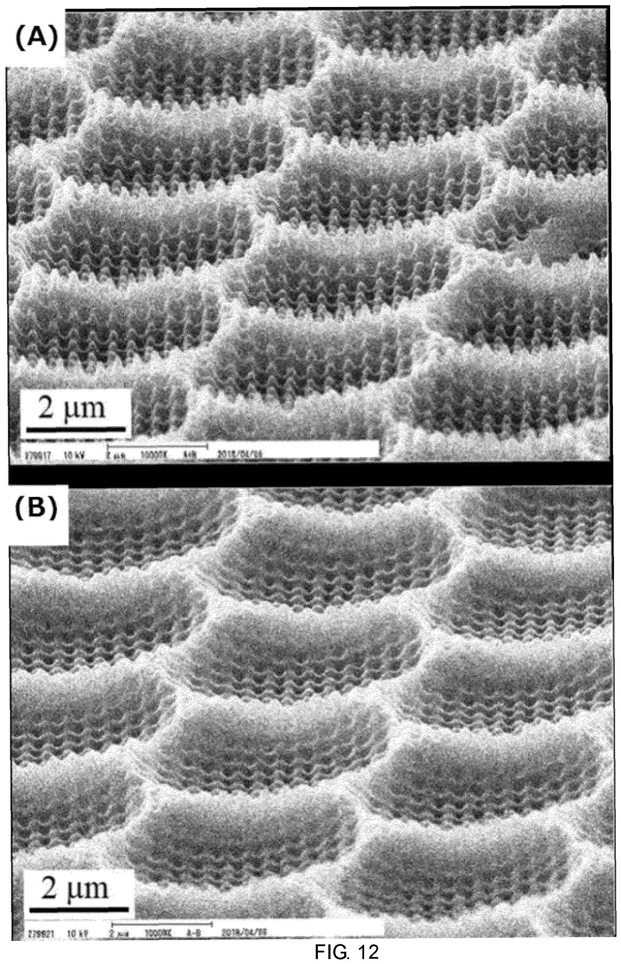

Fig. 12 is a perspective SEM photograph in a case of setting the irradiation dose of the electron beam at (A) 800 µC/cm² and (B) 600 µC/cm². It is found that an aspect ratio can be regulated by regulating the irradiation dose of the electron beam.

### [Example 3]

### 1. Preparation of Imprint Material

### (Synthesis of Photo-Acid Generator Triphenylsulfonium

### Nonafluoro-1-Butanesulfonate)

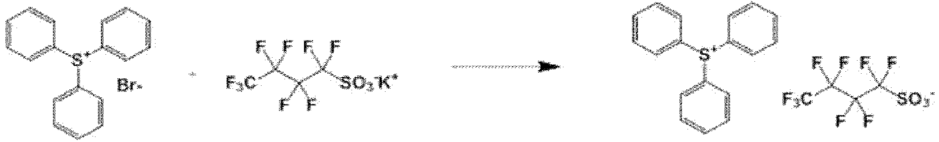

Mixing of 9.9 parts by mass of triphenylsulfonium bromide (manufactured by Tokyo Chemical Industry Co., Ltd.), 10.3 parts by mass of potassium nonafluoro-1-butanesulfonate (manufactured by Tokyo Chemical Industry Co., Ltd.), 70 g of water, and 100 parts by mass of dichloromethane was performed, and the resultant was stirred at 25°C for 1 hour.

The mixed solution was separated into liquids, the organic layer was washed with water four times, and concentrated to dryness by a rotatory evaporator, to obtain 14.5 parts by mass of triphenylsulfonium nonafluoro-1-butanesulfonate. The 1H NMR measurement results of this substance are described below.
1H-NMR (400 MHz/DMSO-d6): δ (ppm) = 7.70 - 8.00 (15H, m)

### (Preparation of Imprint Material A)

Mixing of 73 parts by mass of methyl methacrylate (manufactured by Tokyo Chemical Industry Co., Ltd.) as the monomer that is radically polymerizable, 20 parts by mass of methyladamantyl methacrylate (trade name: MADMA, manufactured by OSAKA ORGANIC CHEMICAL INDUSTRY LTD.) as the compound containing an acid-dissociable group, 2 parts by mass of Omnirad 369 (manufactured by IGM RESINS B.V) as the photo-radical polymerization initiator, and 5 parts by mass of triphenylsulfonium nonafluoro-1-butanesulfonate as the photo-acid generator was performed, and the resultant was further filtered using a PTFE membrane filter (pore diameter of 0.2 µm), to prepare an imprint material A.

### 2. Imprinting with Mold

### (Production of Imprint-Molded Product A)

An adequate amount of the imprint material A was dropwise added onto an alkali-free glass substrate having a thickness of 1.1 mm (trade name: EAGLE XG, manufactured by Corning Incorporated), a film mold having microlens geometry having a period of 7500 nm and a height of 4000 nm (product name: MLTP80-7500, manufactured by Soken Chemical & Engineering Co., Ltd.) was pressed against the imprint material A on the substrate to fill the imprint material A into the pattern, irradiation at a wavelength of 365 nm and an illuminance of 1 W/cm² was performed for 1 hour using a high-pressure mercury lamp, and then the film mold was then peeled to obtain an imprint-molded product A.

The molded product A had a weight-average molecular weight (Mw) of 45000, a number-average molecular weight (Mn) of 2200, and a dispersion degree (Mw/Mn) of 20.5. The weight-average molecular weight and the number-average molecular weight indicate values in terms of standard polystyrene molecular weight, measured by gel permeation chromatography (GPC). A glass transition point thereof was 110°C. The glass transition point is a value measured by TG-DTA.

### 3. Irradiation with ArF Excimer Laser

### (Formation of Dot Pattern on Imprint-Molded Product A)

The imprint-molded product A is exposed to light (at an irradiation angle of 0°) by an ArF excimer laser stepper (wavelength of 193 nm) to achieve a hole pattern having a pattern size of from 300 to 500 nm, and then baked on a hot plate at 100°C for 1 minute. Then, the exposed portion was developed with 2.38% by mass of aqueous tetramethylammonium hydroxide solution for 60 seconds, and then rinsed with pure water for 30 seconds, to obtain a hole pattern having a smaller pattern size of from 300 to 500 nm on the pattern of the imprint-molded product A.

### [Example 4]

### 1. Preparation of Imprint Material

### (Preparation of Imprint Material B)

An imprint material A was prepared by an operation similar to that in the method of Example 3. After irradiation of the imprint material A at a wavelength of 365 nm and an illuminance of 150 mW/cm² for 40 minutes using a high-pressure mercury lamp, the resultant was left to standing to -20°C for 10 minutes to obtain an imprint material B including a prepolymer.

The imprint material B including the prepolymer had a weight-average molecular weight of 30000, a number-average molecular weight (Mn) of 1500, and a dispersion degree (Mw/Mn) of 20.0. The weight-average molecular weight and the number-average molecular weight indicate values in terms of standard polystyrene molecular weight, measured by gel permeation chromatography (GPC).

### 2. Imprinting with Mold

### (Production of Imprint-Molded Product B)

An imprint-molded product B was obtained in a manner similar to that in Example 3 except that the imprint material B was used instead of the imprint material A.

The molded product B had a weight-average molecular weight (Mw) of 50000, a number-average molecular weight (Mn) of 2200, and a dispersion degree (Mw/Mn) of 22.7. The weight-average molecular weight and the number-average molecular weight indicate values in terms of standard polystyrene molecular weight, measured by gel permeation chromatography (GPC). A glass transition point thereof was 110°C.

### 3. Irradiation with ArF Excimer Laser

### (Formation of Dot Pattern on Imprint-Molded Product B)

The imprint-molded product B is exposed to light (at an irradiation angle of 0°) by an ArF excimer laser stepper (wavelength of 193 nm) to achieve a hole pattern having a pattern size of from 300 to 500 nm, and then baked on a hot plate at 100°C for 1 minute. Then, the exposed portion was developed with 2.38% by mass of aqueous tetramethylammonium hydroxide solution for 60 seconds, and rinsed with pure water for 30 seconds, to obtain a hole pattern having a smaller pattern size of from 300 to 500 nm on the pattern of the imprint-molded product B.

### [Example 5]

### (Formation of Dot Pattern on Imprint-Molded Product A)

An imprint-molded product A was obtained by an operation similar to that in the method of Example 3.

The imprint-molded product A is exposed to light (at an irradiation angle of 0°) by an ArF excimer laser stepper (wavelength of 193 nm) to achieve a hole pattern having a pattern size of from 300 to 500 nm, and then baked on a hot plate at 100°C for 1 minute. Then, the unexposed portion was developed with toluene for 60 seconds, and dried to obtain a hole pattern having a smaller pattern size of from 300 to 500 nm on the pattern of the imprint-molded product A.

### [Example 6]

### 1. Preparation of Imprint Material

### (Preparation of Imprint Material C)

Mixing of 83 parts by mass of methyl methacrylate (manufactured by Tokyo Chemical Industry Co., Ltd.) as a photo-radically polymerizable monomer, 10 parts by mass of glycidyl methacrylate (manufactured by Tokyo Chemical Industry Co., Ltd.) as the compound containing an acid-crosslinkable group, 2 parts by mass of Omnirad 369 (manufactured by IGM RESINS B.V) as the photo-radical polymerization initiator, and 5 parts by mass of triphenylsulfonium nonafluoro-1-butanesulfonate synthesized in Example 3 as the photo-acid generator was performed, and the resultant was further filtered using a PTFE membrane filter (pore diameter of 0.2 µm), to prepare an imprint material C.

### 2. Imprinting with Mold

### (Production of Imprint-Molded Product C)

An adequate amount of the imprint material C was dropwise added onto an alkali-free glass substrate having a thickness of 1.1 mm (trade name: EAGLE XG, manufactured by Corning Incorporated), a film mold having microlens geometry having a period of 7500 nm and a height of 4000 nm (product name: MLTP80-7500, manufactured by Soken Chemical & Engineering Co., Ltd.) was pressed against the imprint material C on the substrate to fill the imprint material C into the pattern, irradiation at a wavelength of 365 nm and an illuminance of 150 mW/cm² was performed for 1 hour using a high-pressure mercury lamp, and the film mold was then peeled to obtain an imprint-molded product C.

The imprint-molded product C had a weight-average molecular weight (Mw) of 40000, a number-average molecular weight (Mn) of 2000, and a dispersion degree (Mw/Mn) of 20.0. The weight-average molecular weight and the number-average molecular weight indicate values in terms of standard polystyrene molecular weight, measured by gel permeation chromatography (GPC). A glass transition point thereof was 105°C.

### 3. Irradiation with ArF Excimer Laser

### (Formation of Dot Pattern on Imprint-Molded Product C)

The imprint-molded product C is exposed to light (at an irradiation angle of 0°) by an ArF excimer laser stepper (wavelength of 193 nm) to achieve a hole pattern having a pattern size of from 300 to 500 nm, and then baked on a hot plate at 100°C for 1 minute. Then, the unexposed portion was developed with amyl acetate for 60 seconds, and dried to obtain a hole pattern having a smaller pattern size of from 300 to 500 nm on the pattern of the imprint-molded product B.

### [Example 7]

### 1. Preparation of Imprint Material

### (Preparation of Imprint Material E)

Mixing of 98 parts by mass of methyl methacrylate (manufactured by Tokyo Chemical Industry Co., Ltd.) as the monomer that is radically polymerizable, and 2 parts by mass of Omnirad 369 (manufactured by IGM RESINS B.V) as the photo-radical polymerization initiator was performed, and the resultant was further filtered using a PTFE membrane filter (pore diameter of 0.2 µm), to prepare an imprint material D. An imprint material D was prepared by an operation similar to that in the method of Example 3. After irradiation of the imprint material D at a wavelength of 365 nm and an illuminance of 150 mW/cm² for 40 minutes using a high-pressure mercury lamp, the resultant was left to standing to -20°C for 10 minutes to obtain an imprint material E including a prepolymer.

The imprint material E including the prepolymer had a weight-average molecular weight (Mw) of 29000, a number-average molecular weight (Mn) of 1500, and a dispersion degree (Mw/Mn) of 19.3. The weight-average molecular weight and the number-average molecular weight indicate values in terms of standard polystyrene molecular weight, measured by gel permeation chromatography (GPC).

### 2. Imprinting with Mold

### (Production of Imprint-Molded Product E)

An imprint-molded product E was obtained in a manner similar to that in Example 3 except that the imprint material E was used instead of the imprint material A.

### 3. Irradiation with ArF Excimer Laser

### (Formation of Dot Pattern on Imprint-Molded Product E)

The imprint-molded product B is exposed to light by an ArF excimer laser stepper (wavelength of 193 nm) to achieve a hole pattern having a pattern size of from 300 to 500 nm, and then baked on a hot plate at 100°C for 1 minute. Then, the exposed portion was developed with 2.38% by mass of aqueous tetramethylammonium hydroxide solution for 60 seconds, and rinsed with pure water for 30 seconds, to obtain a hole pattern having a smaller pattern size of from 300 to 500 nm on the pattern of the imprint-molded product B.

The imprint-molded product E had a weight-average molecular weight (Mw) of 35000, a number-average molecular weight (Mn) of 1900, and a dispersion degree (Mw/Mn) of 18.4. The weight-average molecular weight and the number-average molecular weight indicate values in terms of standard polystyrene molecular weight, measured by gel permeation chromatography (GPC). A glass transition point thereof was 105°C.

Based on the above, the producing method in the present invention was described to be useful for producing an antireflective structure. Imprinting (for example, UV-NIL) with this as a master mold can enable to produce a microlens array having a hybrid structure at a high throughput.

### Explanation of References

- 10, 14: Mold
- 20: Resist
- 30: Light
- 40: Imprint-molded product
- 50: Electron beam
- 60: Liquid developer
- 100: Molded product
- 200: Image sensor
- 202: On-chip lens
- 204: Color filter
- 206: Wiring
- 208: Light-receiving surface
- 210: Substrate
- 212: Photodiode
- 214: Incident light

## Claims

1. A method of producing a molded product, the method comprising:
pressing a mold having a surface including at least one of a concave part or a convex part against a photocurable positive electron beam resist;
obtaining a molded product of the positive electron beam resist having a surface including a concave part and a convex part by irradiating the photocurable positive electron beam resist pressed with the mold with light to cure the resist; and
partially decomposing the molded product of the positive electron beam resist in a region subjected to irradiation with an electron beam by irradiating the surface of the molded product of the positive electron beam resist with the electron beam.

2. The method of producing a molded product according to claim 1, wherein a width of a pattern generated by the electron beam, the pattern being formed by partially decomposing the molded product of the positive electron beam resist by the irradiation with the electron beam, is less than a width of at least one of the concave part or the convex part formed by pressing the mold.

3. The method of producing a molded product according to claim 2, wherein at least a part of at least one of the concave part or the convex part has a width in a range of from 1 µm to 5 mm.

4. The method of producing a molded product according to claim 2 or 3, wherein at least a part of the pattern generated by the electron beam has a width in a range of from 10 nm to 800 nm.

5. The method of producing a molded product according to any one of claims 1 to 4, wherein the photocurable positive electron beam resist includes a functional group being radically polymerizable or cationically polymerizable by irradiation with light.

6. The method of producing a molded product according to any one of claims 1 to 5, wherein:
the photocurable positive electron beam resist contains at least one prepolymer selected from the group consisting of a (meth)acrylic compound and a styrenic compound; and
the prepolymer has a functional group being radically polymerizable by irradiation with light.

7. The method of producing a molded product according to any one of claims 1 to 6, wherein:
the molded product of the positive electron beam resist contains a polymer; and
a main chain of the polymer is decomposable by irradiation with an electron beam.

8. The method of producing a molded product according to any one of claims 1 to 7, the method further comprising performing a partial polymerization reaction of the photocurable positive electron beam resist by subjecting the photocurable positive electron beam resist to at least one of heat treatment or light irradiation treatment in advance before the pressing.

9. The method of producing a molded product according to any one of claims 1 to 8, wherein, in the partially decomposing the molded product, at least one of a groove or a through-hole is formed in the molded product of the positive electron beam resist.

10. A resist for collective molding with imprint-electron-beam lithography, the resist comprising a prepolymer containing a functional group being polymerizable by light irradiation,
wherein a main chain of a polymer obtained after the light irradiation of the prepolymer is decomposable by irradiation with an electron beam.

11. A method of producing a molded product, the method comprising:
a process (a) of preparing a mold having a surface including at least one of a first concave part or a first convex part, and an imprint material;
a process (b) of generating a bond between a plurality of molecules included in the imprint material and converting the imprint material into a first film having at least one of a second concave part or a second convex part by subjecting the imprint material to at least one of irradiation with a first energy ray or heat treatment in a state in which the imprint material is in contact with at least a part of at least one of the first concave part or the first convex part;
a process (c) of generating a difference in a physical or chemical property between a first portion of the first film, the first portion being irradiated with a second energy ray, and a second portion other than the first portion by irradiating the first film with the second energy ray; and
a process (d) of forming a molded product in which a structure including at least one of a third concave part or a third convex part is applied to the first film by removing either the first portion or the second portion.

12. The method of producing a molded product according to claim 11, wherein, in the process (b):
the first film contains a polymer; and
the polymer is obtained by polymerizing the imprint material by performing the at least one of the irradiation with the first energy ray or the heat treatment.

13. The method of producing a molded product according to claim 12, wherein bonding or cleaving a part of the polymer in the first portion is induced by the irradiation with the second energy ray in the process (c).

14. The method of producing a molded product according to any one of claims 11 to 13, wherein either the first portion or the second portion is removed by a solvent in the process (d).

15. The method of producing a molded product according to any one of claims 11 to 14, wherein an irradiation angle of the second energy ray is at least one angle in a range of from 0 to 90° with respect to a normal line to a surface of the first film in the process (c).

16. The method of producing a molded product according to any one of claims 11 to 15, wherein an energy of the second energy ray is greater than an energy of the first energy ray.

17. The method of producing a molded product according to any one of claims 11 to 16, wherein a size of width of at least one of the third concave part or the third convex part formed in the process (d) differs from a size of width of at least one of the second concave part or the second convex part formed in the process (b).

18. The method of producing a molded product according to claim 17, wherein at least a part of at least one of the second concave part or the second convex part has a width in a range of from 1 µm to 5 mm.

19. The method of producing a molded product according to claim 17 or 18, wherein at least a part of at least one of the third concave part or the third convex part has a width in a range of from 10 nm to 800 nm.

20. The method of producing a molded product according to any one of claims 11 to 19, wherein the imprint material contains at least one compound having at least one selected from the group consisting of a functional group being radically polymerizable, a functional group being cationically polymerizable, and a functional group being anionically polymerizable, by performing at least one of irradiation with a first energy ray or heat treatment.

21. The method of producing a molded product according to any one of claims 11 to 20, wherein:
the imprint material contains at least one monomer selected from the group consisting of a (meth)acrylic compound and a styrenic compound; and
the monomer contains at least one selected from the group consisting of a functional group being radically polymerizable, a functional group being cationically polymerizable, and a functional group being anionically polymerizable, by performing at least one of irradiation with a first energy ray or heat treatment.

22. The method of producing a molded product according to any one of claims 11 to 21, wherein:
the first film contains a polymer; and
a part of the polymer is decomposable or cross-linkable by the irradiation with the second energy ray.

23. The method of producing a molded product according to any one of claims 11 to 22, further comprising a process of performing partial polymerization reaction of the imprint material by subjecting the imprint material to at least one of heat treatment or light irradiation treatment in advance, before the imprint material in the process (a) is brought into contact with at least one of the concave part or the convex part.

24. The method of producing a molded product according to claim 23, wherein at least one of a groove or a through-hole is formed in the first film in the process (d).

25. The method of producing a molded product according to any one of claims 11 to 24, wherein the molded product is a mold including two or more concave-convex patterns.

26. A method of producing a replica mold, the method comprising:
preparing a mold obtained in the method of producing a molded product according to claim 25, and a resin composition for a replica mold; and
obtaining a replica mold by transferring the two or more concave-convex patterns of the mold to the resin composition for a replica mold, and by curing the resin composition.

27. A method of producing a device, the method comprising:
preparing a mold obtained by the method of producing a molded product according to claim 25 or a replica mold obtained by the method of producing a replica mold according to claim 26; and
forming a pattern by transferring the two or more concave-convex patterns of the mold or the replica mold to a resin composition for transfer, and by curing the resin composition for transfer.

28. An imprint material, comprising a monomer containing a functional group being polymerizable by at least one of irradiation with a first energy ray or heat treatment,
wherein a main chain or a part of a polymer obtained after subjecting the monomer to heating or irradiation with light is decomposable or cross-linkable by irradiation with a second energy ray.
